# EUROPEAN PATENT SPECIFICATION

(11) **EP 3 398 975 B1**
(45) Date of publication and mention of the grant of the patent: **01.02.2023**
(21) Application number: 16881665.0
(22) Date of filing: 20.12.2016
(51) Int. Cl.: C08F 2/50, C09B 23/00, C09B 67/42, C09K 3/00

(54) **PHOTOSENSITIVE COMPOSITION**
LICHTEMPFINDLICHE ZUSAMMENSETZUNG
COMPOSITION PHOTOSENSIBLE

(30) Priority: 29.12.2015 JP 2015257629
(43) Date of publication of application: 07.11.2018
(73) Proprietor: San-Apro Limited, Kyoto-shi, Kyoto 605-0995 (JP)
(72) Inventor: SHIRAISHI Atsushi, Kyoto-shi Kyoto 615-8245 (JP)
(74) Representative: Maiwald GmbH
(86) International application number: PCT/JP2016/087878
(87) International publication number: WO 2017/115690

(56) References cited:
- EP-A1- 2 441 778
- WO-A1-2013/172407
- JP-A- H09 208 574
- JP-A- 2002 023 362
- JP-A- 2007 262 401
- JP-A- 2007 284 550
- JP-A- 2009 075 284
- JP-A- 2009 180 949

## Description

### TECHNICAL FIELD

The present invention relates to a photosensitive composition which is cured by exposing the photosensitive composition to light in a visible-to-infrared region. More particularly, the present invention relates to a photosensitive composition (e.g. a coating agent, a coating material, a lithographic printing plate or the like) which is cured by radiating light in a near-infrared region having a wavelength of 700 nm to 1200 nm, or a photosensitive composition that is suitably used for production of a product or member (e.g. a material for forming an electronic component, an optical product or an optical component, a layer forming material, an adhesive or the like) which is formed through patterning utilizing a difference between solubility of an exposed portion and solubility of an unexposed portion in a developing solution.

### BACKGROUND ART

A UV curing technique for curing a liquid substance by ultraviolet (UV) irradiation has been expanding to a wide application range including coating agents, coating materials, printing inks and the like, because of its workability (fast curability) and reduced VOC.

In general, a photocurable coating agent includes a photopolymerization initiator, a radical-polymerizable monomer, an oligomer or polymer, and a colorant and additive depending on a use. Colorants are classified broadly into pigments and dyes, and blended for coloring a coating film. A colorant not only blocks light, but also has light absorption property corresponding to the color of the colorant, and thus absorbs a part of radiated light, and therefore when a photocurable coating agent containing a colorant is used, there is a case where light does not reach the deep part of the applied coating film. In this connection, use of a specific photopolymerization initiator has been suggested (see, for example, Patent Document 1).

In addition, for using as a light source a small and inexpensive semiconductor laser that is used for a recording material or the like, sensitivity to a long wavelength, particularly to a near infrared region is required. However, a known photosensitive composition does not have sensitivity to a near-infrared region, or does not have sufficiently high sensitivity even if it has sensitivity, and there is a disadvantage that the photosensitive composition does not have sufficient preservability when having high sensitivity.

Thus, a specific initiator has been proposed as an initiator having high sensitivity in a long-wavelength region (see, for example, Patent Documents 2 and 3).

EP 2 441 778 relates to a photosensitive composition including: (1) a radical initiator (A); (2) an acid generator (B) or a base generator (C); (3) a polymerizable substance (D); and (4) a colorant (E), a metal oxide powder (F), or a metal powder (G), wherein at least one of the radical initiator (A), the acid generator (B) and the base generator (C) generates an active species (H) on exposure to active rays, the active species (H) reacts with the radical initiator (A), the acid generator (B) or the base generator (C) to generate another active species (I), the active species (I) in turn causes the polymerizable substance (D) to be polymerized, and the active species (H) or (I) is an acid or a base

However, even photosensitive compositions including specific initiators as described in Patent Documents 1 to 3 have such problems that curability is not sufficient when a substance such as a colorant which attenuates or blocks irradiated light is present at a high concentration, the film thickness is large, or the light source is in a long-wavelength region, and the solubility of the initiator in the composition is low. It is desired to develop an initiator having further high sensitivity.

### PRIOR ART DOCUMENTS

### PATENT DOCUMENTS

Patent Document 1: JP-A-2009-19142
Patent Document 2: JP-A-2-157760
Patent Document 3: JP-A-5-247110

### SUMMARY OF THE INVENTION

### PROBLEMS TO BE SOLVED BY THE INVENTION

An object to be achieved by the present invention is to provide a photosensitive composition having excellent curability even when a substance such as a colorant which attenuates or blocks radiated light is present at a high concentration, the film thickness thereof is large, and the light source is light in a near-infrared region having a wavelength of 700 nm to 1200 nm.

### SOLUTIONS TO THE PROBLEMS

The present inventors have extensively conducted studies for solving said problems, and resultantly found a photosensitive composition having excellent sensitivity to light in a near-infrared region having a wavelength of 700 nm to 1200 nm.

That is, the present invention provides a photosensitive composition containing the following essential components:
(A) an onium salt represented by the general formula (1);
(B) a sensitizer; and
(C) a radical polymerizable compound: 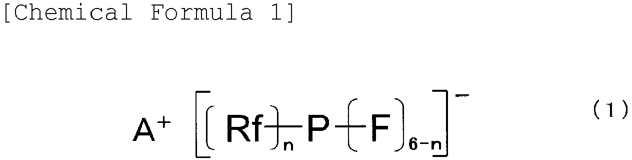
wherein in the formula (1), Rf each independently represents an alkyl group having a carbon number of 1 to 8, an alkenyl group having a carbon number of 2 to 8, or an aryl group having a carbon number of 6 to 10, where 80% or more of hydrogen atoms bonded to the carbon atoms of each group are substituted with fluorine atoms; n represents an integer of 1 to 5; and A⁺ represents a monovalent onium cation,
characterized in that the sensitizer (B) is a polymethine-based dye selected from compounds of chemical formula 5 or chemical formula 6:

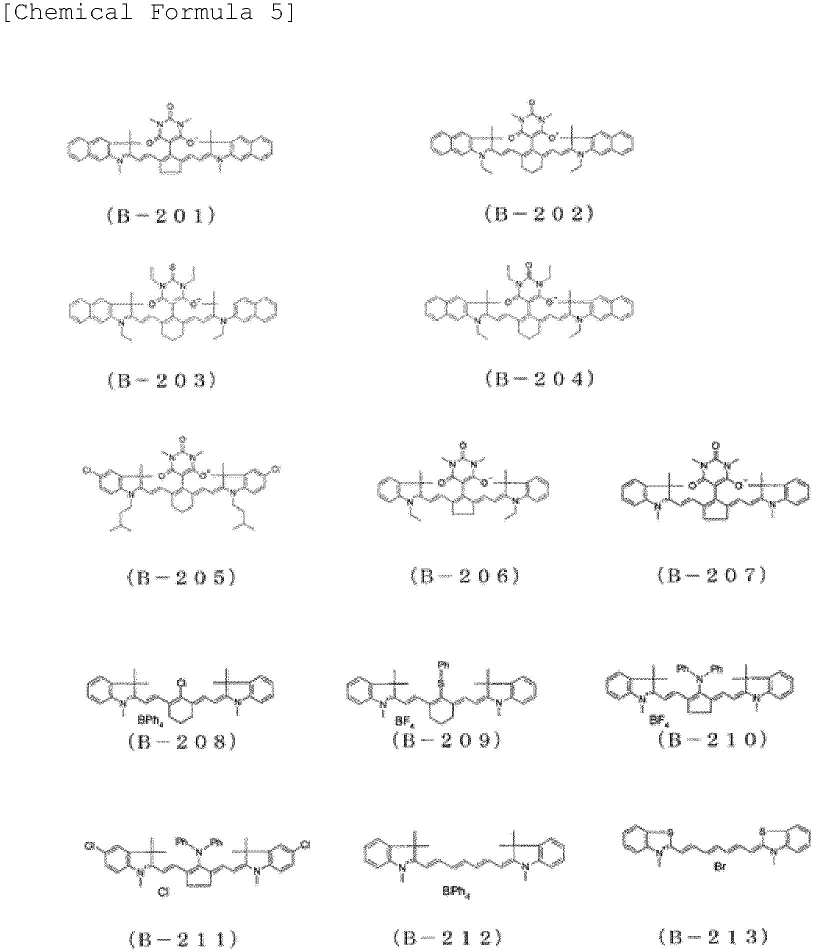

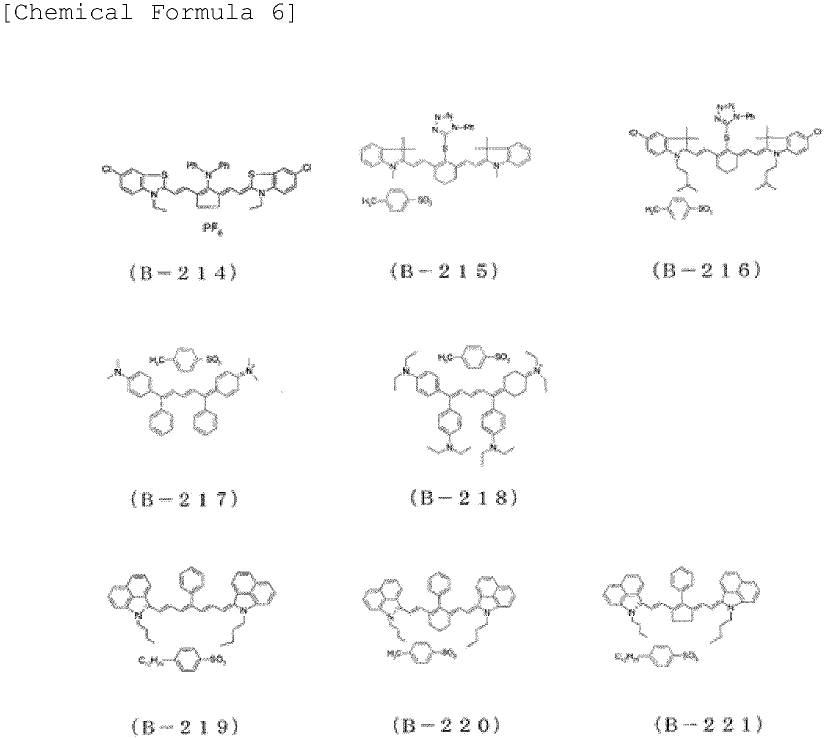

Further, the present invention provides a method for curing a photosensitive composition comprising the step of irradiating the above-described photosensitive composition with light in a near-infrared region having a wavelength of 700 nm to 1200 nm.

Further, the present invention provides a cured product obtained by curing the above-described photosensitive composition by the above-described method.

### EFFECTS OF THE INVENTION

A photosensitive composition of the present invention can be cured by exposing the photosensitive composition to light in a near-infrared region with a wavelength of 700 nm to 1200 nm to efficiently generate radicals. Even when the composition contains an additive and colorant having an absorption in an ultraviolet-to-visible light region, a cured product can be efficiently produced because transmission of an energy ray is not hindered.

### MODE FOR CARRYING OUT THE INVENTION

Hereinafter, embodiments of the present invention will be described in detail.

A photosensitive composition of the present invention contains an onium salt (A) represented by the general formula (1).

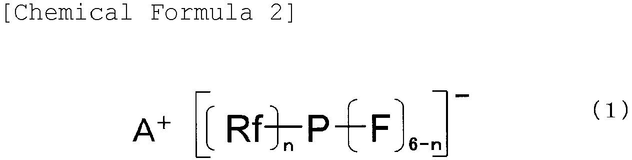

In the formula (1), Rf each independently represents an alkyl group having a carbon number of 1 to 8, an alkenyl group having a carbon number of 2 to 8, or an aryl group having a carbon number of 6 to 10, where 80% or more of hydrogen atoms bonded to the carbon atoms of each group are substituted with fluorine atoms; n represents an integer of 1 to 5; and A⁺ represents a monovalent onium cation.

Examples of the alkyl group having a carbon number of 1 to 8 include linear alkyl groups such as methyl, ethyl, propyl, butyl, pentyl, hexyl, heptyl and octyl; branched alkyl groups such as isopropyl, isobutyl, sec-butyl, tert-butyl, isopentyl, neopentyl, tert-pentyl and isohexyl; and cycloalkyl groups such as cyclopropyl, cyclobutyl, cyclopentyl and cyclohexyl.

Examples of the alkenyl group having a carbon number of 2 to 8 include linear or branched alkenyl groups such as vinyl, allyl, 1-propenyl, isopropenyl, 1-butenyl, 2-butenyl, 3-butenyl, 1-methyl-1-propenyl, 1-methyl-2-propenyl, 2-methyl-1-propenyl, 2-methyl-2-propenyl, 1-pentenyl, 2-pentenyl, 3-pentenyl, 4-pentenyl, 1-methyl-1-butenyl, 2-methyl-2-butenyl, 3-methyl-2-butenyl and 1,2-dimethyl-1-propenyl.

Examples of the aryl group having a carbon number of 6 to 10 (excluding the carbon numbers of the following substituents) include a phenyl group, a naphthyl group and aromatic heterocyclic hydrocarbon groups (monocyclic heterocyclic rings such as thienyl, furanyl, pyranyl, pyrrolyl, oxazolyl, thiazolyl, pyridyl, pyrimidyl and pyrazinyl; and fused polycyclic heterocyclic rings such as indolyl, benzofuranyl, isobenzofuranyl, benzothienyl, isobenzothienyl, quinolyl, isoquinolyl, quinoxalinyl and quinazolinyl).
Examples of the aryl group may include, in addition to the above-mentioned aryl groups, those in which some of hydrogen atoms in the aryl group are substituted with alkyl groups having a carbon number of 1 to 8 or alkenyl groups having a carbon number of 2 to 8.

In the formula (1), Rf is a group in which 80% or more of hydrogen atoms bonded to the carbon atoms in the above-described alkyl group having a carbon number of 1 to 8, alkenyl group having a carbon number of 2 to 8, or aryl group having a carbon number of 6 to 10 are substituted with fluorine atoms. Preferably 90% or more of the hydrogen atoms, more preferably 100% of the hydrogen atoms are substituted with fluorine atoms. When the fluorine atom substitution ratio is less than 80%, the polymerization-initiating ability is deteriorated in the photosensitive composition of the present invention.
Rf is preferably an alkyl group having a carbon number of 1 to 8, a phenyl group or a naphthyl group, more preferably an alkyl group having a carbon number of 1 to 4 from the viewpoint of availability of a raw material. Rf is especially preferably an alkyl group having a carbon number of 1 to 4 and a fluorine atom substitution ratio of 100%, and specific examples thereof include CF₃, CF₃CF₂, (CF₃)₂CF, CF₃CF₂CF₂, CF₃CF₂CF₂CF₂, (CF₃)₂CFCF₂, CF₃CF₂ (CF₂)CF, and (CF₃)₂C.

In the formula (1), n represents the number of substituents Rf substituted on phosphorus atoms, and is an integer of 1 to 5.

From the viewpoint of acquisition of a raw material, n is preferably 1 to 3, especially preferably 2 to 3.

Specific examples of the preferred fluorinated alkylfluorophosphate anion include [(CF₃)PF₅]⁻, [(CF₃)₂PF₄]⁻, [(CF₃)₃PF_{3]}⁻, [(CF₃CF₂)PF₅]⁻, [(CF₃CF₂)₂PF₄]⁻, [(CF₃CF₂)₃PF₃]⁻, [((CF₃)₂CF)PF₅]⁻, [((CF₃)₂CF)₂PF₄]⁻, [((CF₃)₂CF)₃PF₃]⁻, [(CF₃CF₂CF₂)PF₅]⁻, [(CF₃CF₂CF₂)₂PF₄]⁻, [(CF₃CF₂CF₂)₃PF₃]⁻, [((CF₃)₂CFCF₂)PF₅]⁻, [((CF₃)₂CFCF₂)₂PF₄]⁻, [((CF₃)₂CFCF₂)₃PF₃]⁻, [(CF₃CF₂CF₂CF₂)PF₅]⁻, [(CF₃CF₂CF₂CF₂)₂PF₄]⁻ and [(CF₃CF₂CF₂CF₂)₃PF₃]⁻, and among them, [(CF₃)₂PF₄] [(CF₃)₃PF₃]⁻, [(CF₃CF₂)₂PF₄]⁻, [(CF₃CF₂)₃PF₃]⁻, [((CF₃)₂CF)₂PF₄]⁻, [((CF₃)₂CF)₃PF₃]⁻, [(CF₃CF₂CF₂)₂PF₄]⁻, [(CF₃CF₂CF₂)₃PF₃]⁻, [((CF₃)₂CFCF₂)₂PF₄]⁻ _{,} [((CF₃)₂CFCF₂)₃PF₃]⁻, [(CF₃CF₂CF₂CF₂)₂PF₄]⁻ and [(CF₃CF₂CF₂CF₂)₃PF₃]⁻ are especially preferable.

In the formula (1), A⁺ is a monovalent onium cation.

The monovalent onium cation means a cation generated by coordinating a proton or a cationic atomic group (e.g. alkyl group) to a compound containing an element having an unshared electron pair, and examples of the monovalent onium cation include the following cations:
oxonium cations (e.g. trimethyloxonium cation, triethyloxonium and tetramethylenemethyloxonium cation); pyririnium cations (e.g. 4-methylpyririnium cation and 2,6-diphenylpyririnium cation);
chromenium cations (e.g. 2,4-dimethylchromenium cation); isochromenium cations (e.g. 1,3-dimethylisochromenium cation);
ammonium cations [ammonium cations, primary ammonium cations (e.g. n-butylammonium cation), secondary ammonium cations (e.g. diethylammonium cation), tertiary ammonium cation (e.g. triethylammonium cation), quaternary ammonium cations (tetramethylammonium cation, phenyltrimethyl ammonium cation and tetrabutylammonium cation)];
pyrrolidinium cations (e.g. N,N-dimethylpyrrolidinium cation and N,N-diethylpyrrolidinium cation); imidazolinium cations (e.g. N,N'-dimethylimidazolinium cation and N-ethyl-N'-methylimidazolinium cation); amidinium cations (e.g. N,N'-dimethyltetrahydropyrimidinium cation, N-benzyl-1,8-diazabicyclo[5.4.0]-7-undecenium cation and N-benzyl-1,5-diazabicyclo[4.3.0]-5-nonenium cation);
morpholinium cations (e.g. N,N'-dimethylmorpholinium cation), piperidium cations (N, N'-diethylpiperidinium cation);
pyridinium cations (e.g. N-methylpyridinium cation, N-methoxypyridinium cation, N-butoxypyridinium cation, N-benzyloxypyridinium cation, and N-benzylpyridinium cation);
imidazolium cations (e.g. N,N'-dimethylimidazolium cation and 1-ethyl-3-methylimidazolium cation); quinolium cations (e.g. N-methylquinolium cation and N-benzyl quinolium cation);
isoquinolium cations (e.g. N-methylisoquinolium);
thiazonium cations (e.g. benzylbenzothiazonium cation);
acridium cations (e.g. benzylacridium cation and phenacylacridium);
diazonium cations (e.g. phenyldiazonium cation, 2,4,6-triethoxyphenyldiazonium cation, 2,4,6-trihexyloxyphenyldiazonium cation and 4-anilinophenyldiazonium cation);
guanidinium cations (e.g. hexamethylguanidinium cation and 2-benzyl-2-tert-butyl-1,1,3,3-tetramethylguanidinium cation);
phosphonium cations [e.g. tertiary phosphonium cations (e.g. triphenylphosphonium cation and tri-tert-butylphosphonium cation) and quaternary phosphonium cations (e.g. tetraphenylphosphonium cation, tetra-p-tolylphosphonium cation, triphenylbenzylphosphonium cation, triphenylbutyl cation and tetraethylphosphonium cation and tetrabutylphosphonium cation)];
sulfonium cations {e.g. triphenylsulfonium cation, 4-(phenylthio)phenyldiphenylsulfonium cation, bis[4-(diphenylsulfonio)phenyl]sulfide and 4-hydroxyphenylmethylbenzylsulfonium cation};
sulfoxonium cations (e.g. triphenylsulfoxonium); thianthrenium cations [e.g. 5-(4-methoxyphenyl)thianthrenium, 5-phenylthianthrenium and 5-tolylthianthrenium cation];
thiophenium cations (e.g. 2-naphthyl tetrahydrothiophenium); and
iodonium cations [e.g. diphenyliodonium cation, di-p-tolyliodonium cation and 4-isopropylphenyl(p-tolyl)iodonium cation].

Among the above-described onium cations, sulfonium cations, iodonium cations, diazonium cations and pyridinium cations are preferable from the viewpoint of reactivity, and sulfonium cations and iodonium cations are especially preferable from the viewpoint of thermal stability.

Specific examples of the preferred iodonium cation include a diphenyliodonium cation, a di-p-tolyliodonium cation and a 4-isopropylphenyl(p-tolyl)iodonium cation as well as a di-(4-tertbutyl)phenyliodonium cation, a 4-octyloxyphenylphenyliodonium cation, a di-4-isopropylphenyliodonium cation, a bis(2,4-diisopropylphenyl)iodonium cation, a 4-hexylphenyl(p-tolyl)iodonium cation, a 4-cyclohexylphenyl(p-tolyl)iodonium cation, a bis(4-dodecylphenyl)iodonium cation, a bis(4-methoxyphenyl)iodonium cation, a bis(4-decyloxy)phenyliodonium cation and a 4-(2-hydroxytetradecyloxy)phenylphenyliodonium cation.

Specific examples of the preferred sulfonium cation include the above-described triphenylsulfonium cation, 4-(phenylthio)phenyldiphenylsulfonium cation, bis[4-(diphenylsulfonio)phenyl]sulfide and 4-hydroxyphenylmethylbenzylsulfonium cation as well as a tris(4-chlorophenyl)sulfonium cation, a tris(4-fluorophenyl)sulfonium cation, a 4-tert-butylphenyldiphenylsulfonium cation and a diphenylphenacylsulfonium cation.

Specific examples of the preferred iodonium salt include the following.

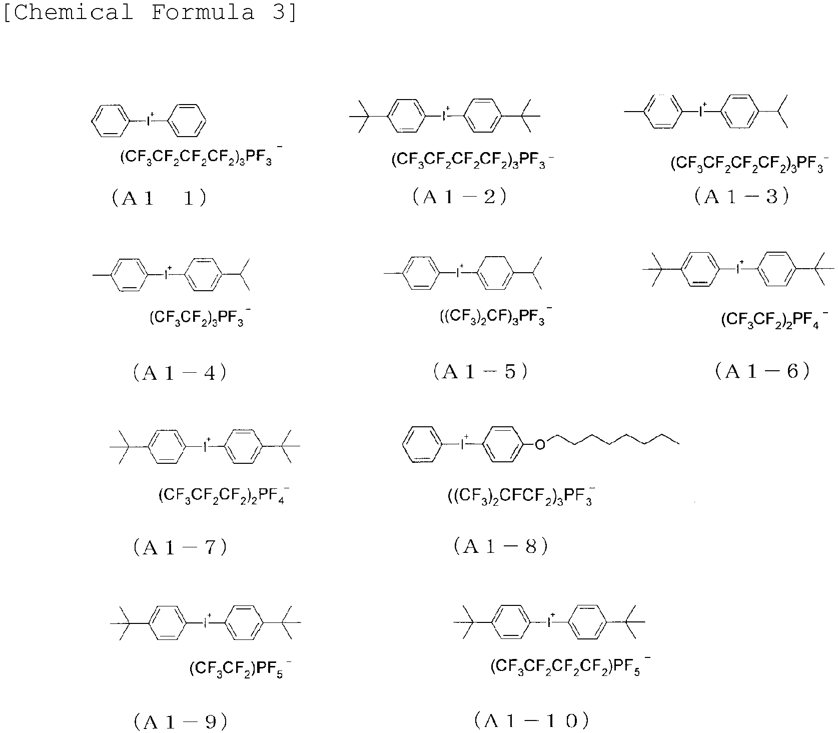

Specific examples of the preferred sulfonium salt include the following.

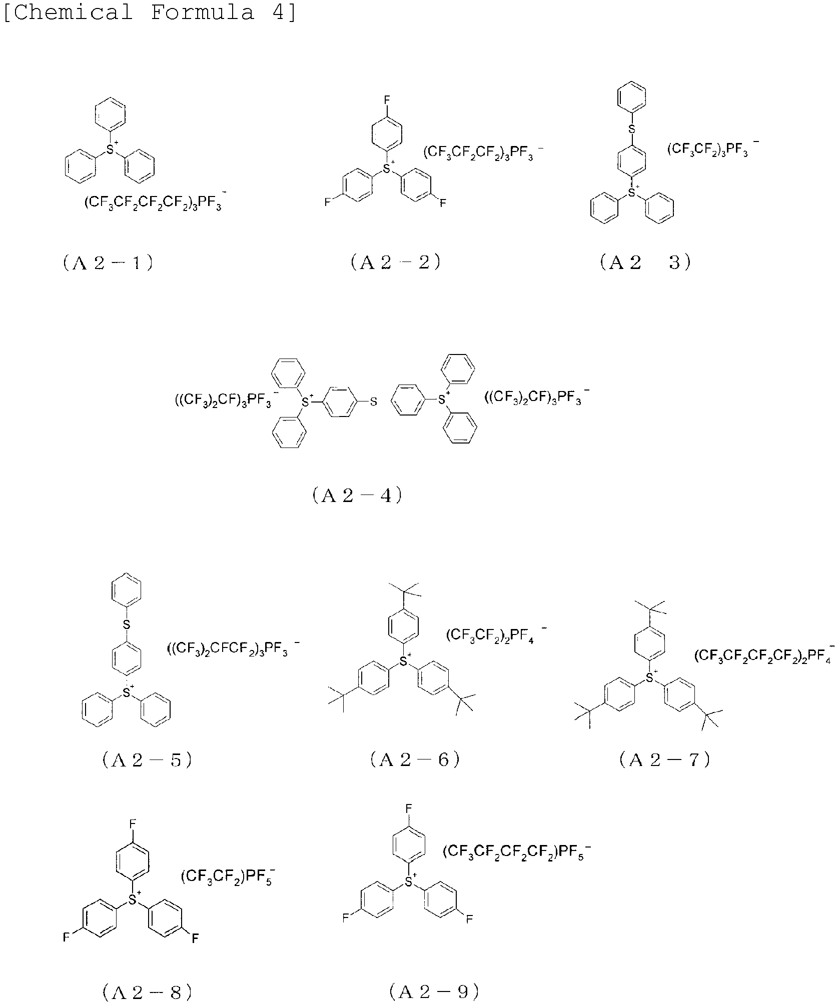

The onium salt represented by the general formula (1) in the present invention can be produced by a double decomposition method. In the double decomposition method which is described in, for example, New Experimental Chemistry Vol. 14-I (Maruzen Publishing Co., Ltd., 1978), p. 448; Advance in Polymer Science, 62, 1-48 (1984); New Experimental Chemistry Vol. 14-III (Maruzen Publishing Co., Ltd., 1978), pp. 1838-1846; Organic Sulfur Chemistry (Synthetic Reaction, 1982, Kagaku-Dojin Publishing Company, INC), chapter 8, pp 237-280; Journal of the Chemical Society of Japan, 87, (5), 74 (1966); JP-A-64-45357, JP-A-61-212554, JP-A-61-100557, JP-A-5-4996, JP-A-7-82244, JP-A-7-82245, JP-A-58-210904 and JP-A-6-184170, first a salt of an onium cation with a halogen ion such as F⁻, Cl⁻, Br⁻ or I⁻; OH⁻; ClO₄⁻; a sulfonate ion such as FSO₃⁻, ClSO₃⁻, CH₃SO₃⁻, C₆H₅SO₃⁻ or CF₃SO₃⁻; a sulfate ion such as HSO₄⁻ or SO₄²⁻; a carbonate ion such as HCO₃⁻ or CO₃²⁻; a phosphate ion such as H₂PO₄⁻, HPO₄²⁻ or PO₄³⁻ ; or the like is produced, and added in a solvent or aqueous solution containing an alkali metal salt, alkali earth metal salt or quaternary ammonium salt that forms an onium salt represented by the formula (1), and other anion components such as KPF₆, KBF₄ and LiB(C₆F₅)₄ as necessary, in a theoretical amount or more, and the mixture is subjected to double decomposition. As a solvent, water or an organic solvent can be used. Examples of the organic solvent include hydrocarbons (e.g. hexane, heptane, toluene, and xylene), cyclic ethers (e.g. tetrahydrofuran and dioxane), chlorinated solvents (e.g. chloroform and dichloromethane), alcohols (e.g. methanol, ethanol and isopropyl alcohol), ketones (e.g. acetone, methyl ethyl ketone and methyl isobutyl ketone), nitriles (e.g. acetonitrile) and polar organic solvents (dimethylsulfoxide, dimethylformamide and N-methylpyrrolidone). One of these solvents may be used alone, or two or more thereof may be used in combination.

A desired onium salt generated in this way is separated in the form of crystals or an oil. In the case of an oil, the onium salt is obtained by separating the precipitated oil from the organic solvent solution, and distilling off the organic solvent contained in the oil. In the case of crystals, the onium salt is obtained by separating the precipitated solid from the organic solvent solution, and distilling off the organic solvent contained in the solid. The desired onium salt thus obtained can be purified by recrystallization or washing with water or a solvent as necessary.

Purification by recrystallization can be performed by dissolving the desired onium salt in a small amount of an organic solvent, and separating the desired onium salt from the organic solvent by precipitating the desired onium salt by adding a poor solvent directly (or after concentration) to an organic solvent solution containing the desired onium salt. Examples of the poor solvent used here include chain ethers (e.g. diethyl ether and dipropyl ether), esters (e.g. ethyl acetate and butyl acetate), aliphatic hydrocarbons (e.g. hexane and cyclohexane) and aromatic hydrocarbons (e.g. toluene and xylene). Purification can also be performed utilizing a temperature-dependent difference in solubility. Purification can be performed by recrystallization (a method utilizing difference in solubility in cooling, a method in which a poor solvent is added to precipitate the onium salt, or a combination of these methods). In addition, when the onium salt is an oil (when onium salt is not crystallized), purification can be performed by a method in which the oil is washed with water or a poor solvent.

The structure of the onium salt thus obtained can be identified by a general analysis method such as nuclear magnetic resonance spectrum of ¹H, ¹³C, ¹⁹F, ³¹P and the like, infrared absorption spectrum or elemental analysis.

The fluorinated alkylfluorophosphate to be used for the above-described double decomposition reaction is preferably a salt of an alkali metal from the viewpoint of reactivity. This salt is obtained by reacting a fluorinated alkylfluorophosphorane as a precursor with an alkali metal fluoride in an aprotic solvent such as dimethyl ether, diethoxyethane, acetonitrile or a mixture thereof at -35 to 60°C (US Patent No. 6210830).

The fluorinated alkylfluorophosphorane as a precursor is obtained by, for example, a method in which an alkylphosphine is electrochemically fluorinated with hydrofluoric acid at a temperature of -15 to 20°C under normal pressure (US Patent No. 6264818). Electrochemical fluorination proceeds in proportion to the amount of electricity, and fluorination is normally ended at the time when 90 to 150%, particularly 110 to 130%, of the theoretical amount of electricity is consumed. Accordingly, a fluorinated alkylfluorophosphorane is obtained in which 80% or more, preferably 90% or more, of hydrogen atoms in the alkyl group is substituted with fluorine. The desired fluorinated alkylfluorophosphorane is separated from an electrolytic solution, and is therefore recovered by liquid separation, and purified by distillation as necessary.

The radical-polymerizable compound (C) contained in the photosensitive composition of the present invention is not particularly limited as long as it is a compound that is polymerized by radicals, and a known compound can be used.

Examples thereof include acrylamide compounds (C11) having a carbon number of 3 to 35, (meth)acrylate compounds (C12) having a carbon number of 4 to 35, aromatic vinyl compounds (C13) having a carbon number of 6 to 35, vinyl ether compounds (C14) having a carbon number of 3 to 20, and other radical-polymerizable compounds (C15).

In the above and hereinafter, the "(meth)acrylate" may correspond to either or both of the "acrylate" and the "methacrylate", and the "(meth)acryl" may correspond to either of both of the "acryl" and the "methacryl".

Examples of the (meth)acrylamide compound (C11) having a carbon number of 3 to 35 include (meth)acrylamide, N-methyl (meth)acrylamide, N-ethyl (meth)acrylamide, N-propyl (meth)acrylamide, N-n-butyl (meth)acrylamide, N-t-butyl (meth)acrylamide, N-butoxymethyl (meth)acrylamide, N-isopropyl (meth)acrylamide, N-methylol (meth)acrylamide, N,N-dimethyl (meth)acrylamide, N,N-diethyl (meth)acrylamide and (meth)acryloylmorpholine.

Examples of the (meth)acrylate compound (C12) having a carbon number of 4 to 35 include the following monofunctional to hexafunctional (meth)acrylates.

Examples of the monofunctional (meth)acrylate include ethyl (meth)acrylate, hexyl (meth)acrylate, 2-ethylhexyl (meth)acrylate, tert-octyl (meth)acrylate, isoamyl (meth)acrylate, decyl (meth)acrylate, isodecyl (meth)acrylate, stearyl (meth)acrylate, isostearyl (meth)acrylate, cyclohexyl (meth)acrylate, 4-n-butylcyclohexyl (meth)acrylate, bornyl (meth)acrylate, isobornyl (meth)acrylate, benzyl (meth)acrylate, 2-ethylhexyl diglycol (meth)acrylate, butoxyethyl (meth)acrylate, 2-chloroethyl (meth)acrylate, 4-bromobutyl (meth)acrylate, cyanoethyl (meth)acrylate, benzyl (meth)acrylate, butoxymethyl (meth)acrylate, methoxypropylene monoacrylate, 3-methoxybutyl (meth)acrylate, alkoxymethyl (meth)acrylate, 2-ethylhexylcarbitol (meth)acrylate, alkoxyethyl (meth)acrylate, 2-(2-methoxyethoxy)ethyl (meth)acrylate, 2-(2-butoxyethoxy)ethyl (meth)acrylate, 2,2,2-tetrafluoroethyl (meth)acrylate, 1H,1H,2H,2H-perfluorodecyl (meth)acrylate, 4-butylphenyl (meth)acrylate, phenyl (meth)acrylate, 2,4,5-tetramethylphenyl (meth)acrylate, 4-chlorophenyl (meth)acrylate, phenoxymethyl (meth)acrylate, phenoxyethyl (meth)acrylate, glycidyl (meth)acrylate, glycidyloxybutyl (meth)acrylate, glycidyloxyethyl (meth)acrylate, glycidyloxypropyl (meth)acrylate, diethylene glycol monovinyl ether monoacrylate, tetrahydrofurfuryl (meth)acrylate, hydroxyalkyl (meth)acrylate, 2-hydroxyethyl (meth)acrylate, 3-hydroxypropyl (meth)acrylate, 2-hydroxypropyl (meth)acrylate, 2-hydroxybutyl (meth)acrylate, 4-hydroxybutyl (meth)acrylate, dimethylaminoethyl (meth)acrylate, diethylaminoethyl (meth)acrylate, dimethylaminopropyl (meth)acrylate, diethylaminopropyl (meth)acrylate, trimethoxysilylpropyl (meth)acrylate, trimethoxysilylpropyl (meth) acrylate, trimethylsilylpropyl (meth)acrylate, polyethylene oxide monomethyl ether (meth)acrylate, oligoethylene oxide monomethyl ether (meth)acrylate, polyethylene oxide (meth)acrylate, oligoethylene oxide (meth)acrylate, oligoethylene oxide monoalkyl ether (meth)acrylate, polyethylene oxide monoalkyl ether (meth)acrylate, dipropylene glycol (meth)acrylate, polypropylene oxide monoalkyl ether (meth)acrylate, oligopropylene oxide monoalkyl ether (meth)acrylate, 2-methacryloyloxyethylsuccinic acid, 2-methacryloyloxyhexahydrophthalic acid, 2-methacryloyloxyethyl-2-hydroxypropyl phthalate, butoxydiethylene glycol (meth)acrylate, trifluoroethyl (meth)acrylate, perfluorooctylethyl (meth)acrylate, 2-hydroxy-3-phenoxypropyl (meth)acrylate, EO-modified phenol (meth)acrylate, EO-modified cresol (meth)acrylate, EO-modified nonylphenol (meth)acrylate, PO-modified nonylphenol (meth)acrylate and EO-modified 2-ethylhexyl (meth)acrylate.

Examples of the difunctional (meth)acrylate include 1,4-butane di(meth)acrylate, 1,6-hexane diacrylate, polypropylene diacrylate, 1,6-hexanediol di(meth)acrylate, 1,10-decanediol di(meth)acrylate, neopentyl diacrylate, neopentyl glycol di(meth)acrylate, 2,4-dimethyl-1,5-pentanediol di(meth)acrylate, butylethylpropanediol (meth)acrylate, ethoxylated cyclohexane methanol di(meth)acrylate, polyethylene glycol di(meth)acrylate, oligoethylene glycol di(meth)acrylate, ethylene glycol di(meth)acrylate, 2-ethyl-2-butyl-butanediol di(meth)acrylate, hydroxypivalic acid neopentyl glycol di(meth)acrylate, EO-modified bisphenol A di(meth)acrylate, bisphenol F polyethoxy di(meth) acrylate, polypropylene glycol di(meth)acrylate, oligopropylene glycol di(meth)acrylate, 1,4-butanediol di(meth)acrylate, 2-ethyl-2-butyl-propanediol di(meth)acrylate, 1,9-nonane di(meth)acrylate, propoxylated ethoxylated bisphenol A di(meth) acrylate and tricyclodecane di(meth)acrylate.

Examples of the trifunctional (meth)acrylate include trimethylolpropane tri(meth)acrylate, trimethylolethane tri(meth)acrylate, alkylene oxide-modified tri(meth)acrylate of trimethylolpropane, pentaerythritol tri(meth)acrylate, dipentaerythritol tri(meth)acrylate, trimethylolpropane tri((meth)acryloyloxypropyl)ether, alkylene oxide isocyanurate-modified tri(meth)acrylate, dipentaerythritol tri(meth)acrylate propionate, (tri(meth)acryloyloxyethyl)isocyanurate, hydroxypivalaldehyde-modified dimethylolpropane tri(meth)acrylate, sorbitol tri(meth)acrylate, propoxylated trimethylolpropane tri(meth)acrylate and ethoxylated glycerin triacrylate.

Examples of the tetrafunctional (meth)acrylate include pentaerythritol tetra(meth)acrylate, sorbitol tetra(meth)acrylate, ditrimethylolpropane tetra(meth)acrylate, dipentaerythritol propionate tetra(meth)acrylate and ethoxylated pentaerythritol tetra(meth)acrylate.

Examples of the pentafunctional (meth)acrylate include sorbitol penta(meth)acrylate and dipentaerythritol penta(meth)acrylate.

Examples of the hexafunctional (meth)acrylate include dipentaerythritol hexa(meth)acrylate, sorbitol hexa(meth)acrylate, alkylene oxide-modified hexa(meth)acrylate of phosphazene and caprolactone-modified dipentaerythritol hexa(meth)acrylate.

Examples of the aromatic vinyl compound (C13) having a carbon number of 6 to 35 include vinylthiophene, vinylfuran, vinylpyridine, styrene, methylstyrene, trimethylstyrene, ethylstyrene, isopropylstyrene, chloromethylstyrene, methoxystyrene, acetoxystyrene, chlorostyrene, dichlorostyrene, bromostyrene, vinylbenzoic acid methyl ester, 3-methylstyrene, 4-methylstyrene, 3-ethylstyrene, 4-ethylstyrene, 3-propylstyrene, 4-propylstyrene, 3-butylstyrene, 4-butylstyrene, 3-hexylstyrene, 4-hexylstyrene, 3-octylstyrene, 4-octylstyrene, 3-(2-ethylhexyl)styrene, 4-(2-ethylhexyl)styrene, allylstyrene, isopropenylstyrene, butenylstyrene, octenylstyrene, 4-t-butoxycarbonylstyrene, 4-methoxystyrene and 4-t-butoxystyrene.

Examples of the vinyl ether compound (C14) having a carbon number of 3 to 35 include the following monofunctional or polyfunctional vinyl ethers.

Examples of the monofunctional vinyl ether include methyl vinyl ether, ethyl vinyl ether, propyl vinyl ether, n-butyl vinyl ether, t-butyl vinyl ether, 2-ethylhexyl vinyl ether, n-nonyl vinyl ether, lauryl vinyl ether, cyclohexyl vinyl ether, cyclohexyl methyl vinyl ether, 4-methylcyclohexyl methyl vinyl ether, benzyl vinyl ether, dicyclopentenyl vinyl ether, 2-dicyclopentenoxyethyl vinyl ether, methoxyethyl vinyl ether, ethoxyethyl vinyl ether, butoxyethyl vinyl ether, methoxyethoxyethyl vinyl ether, ethoxyethoxyethyl vinyl ether, methoxypolyethylene glycol vinyl ether, tetrahydrofurfuryl vinyl ether, 2-hydroxyethyl vinyl ether, 2-hydroxypropyl vinyl ether, 4-hydroxybutyl vinyl ether, 4-hydroxymethylcyclohexyl methyl vinyl ether, diethylene glycol monovinyl ether, polyethylene glycol vinyl ether, chloroethyl vinyl ether, chlorobutyl vinyl ether, chloroethoxyethyl vinyl ether, phenylethyl vinyl ether and phenoxypolyethylene glycol vinyl ether.

Examples of the polyfunctional vinyl ether include divinyl ethers such as ethylene glycol divinyl ether, diethylene glycol divinyl ether, polyethylene glycol divinyl ether, propylene glycol divinyl ether, butylene glycol divinyl ether, hexane diol divinyl ether, bisphenol A alkylene oxide divinyl ether and bisphenol F alkylene oxide divinyl ether; and trimethylolethane trivinyl ether, trimethylolpropane trivinyl ether, ditrimethylolpropane tetravinyl ether, glycerin trivinyl ether, pentaerythritol tetravinyl ether, dipentaerythritol pentavinyl ether, dipentaerythritol hexavinyl ether, ethylene oxide-added trimethylolpropane trivinyl ether, propylene oxide-added trimethylolpropane trivinyl ether, ethylene oxide-added ditrimethylolpropane tetravinyl ether, propylene oxide-added ditrimethylolpropane tetravinyl ether, ethylene oxide-added pentaerythritol tetravinyl ether, propylene oxide-added pentaerythritol tetravinyl ether, ethylene oxide-added dipentaerythritol hexavinyl ether and propylene oxide-added dipentaerythritol hexavinyl ether.

Examples of the other radical-polymerizable compound (C15) include acrylonitrile, vinyl ester compounds (e.g. vinyl acetate, vinyl propionate and vinyl versatate), maleimide compounds (e.g. 1-methyl-2,4-bismaleimidebenzene and N,N'-m-phenylene bismaleimide), allyl ester compounds (e.g. allyl acetate), halogen-containing monomers (e.g. vinylidene chloride and vinyl chloride) and olefin compounds (e.g. ethylene and propylene) as well as oligomers having a plurality of (meth)acrylate groups. Examples of the polyfunctional (meth)acrylate oligomer include oligomers such as epoxy (meth)acrylate oligomers, urethane (meth)acrylate oligomers, polyether (meth)acrylate oligomers, polysiloxane (meth)acrylate oligomers and polyester (meth)acrylate oligomers.

Among them, acrylamide compounds (C11) having a carbon number of 3 to 35, (meth)acrylate compounds (C12) having a carbon number of 4 to 35, aromatic vinyl compounds (C13) having a carbon number of 6 to 35 and vinyl ether compounds (C14) having a carbon number of 3 to 20 are preferable, and acrylamide compounds (C11) having a carbon number of 3 to 35 and (meth)acrylate compounds (C12) having a carbon number of 4 to 35 are more preferable, from the view point of a curing rate.

In the photosensitive composition of the present invention, the content of the onium salt represented by the general formula (1) can in an embodiment be 0.5% by weight to 30% by weight, preferably 0.1% by weight to 20% by weight, still more preferably 1% by weight to 10% by weight based on the total weight of the onium salt and the radical-polymerizable compound (C). Two or more kinds of onium salts represented by the general formula (1) may be used in combination.

The photosensitive composition of the present invention may contain other additives (J) that are generally used for controlling the appearance and physical properties of a cured product of a photosensitive composition. Other additives (J) include a colorant (Ja), metal oxide particles (Jb) and metal particles (Jc).

As the colorant (Ja) in the present invention, pigments such as inorganic pigments and organic pigments, and dyes which have been heretofore used for coating materials, inks and the like can be used.

Examples of the inorganic pigment include chrome yellow, zinc yellow, iron blue, barium sulfate, cadmium red, titanium oxide, zinc white, red oxide, alumina, calcium carbonate, ultramarine blue, carbon black, graphite and titanium black.

Examples of the organic pigment include soluble azo pigments such as β-naphthol systems, β-oxynaphthoic acid-based anilide systems, acetoacetanilide systems and pyrazolone systems; insoluble azo pigments such as β-naphthol systems, β-oxynaphthoic acid systems, β-oxynaphthoic acid-based anilide systems, acetoacetanilide-based monoazo, acetoacetanilide-based disazo and pyrazolone systems; phthalocyanine-based pigments such as copper phthalocyanine blue, halogenated copper phthalocyanine blue, sulfonated copper phthalocyanine blue and metal-free phthalocyanine; and polycyclic or heterocyclic compounds such as isoindolinone systems, quinacridone systems, dioxazine systems, perinone systems and a perylene systems.

As specific examples of the dye, examples of the yellow dye include aryl or heteryl azo dyes having a phenol, a naphthol, an aniline, a pyrazolone, a pyridone or an open chain active methylene compounds as a coupling component; methine dyes such as azomethine dyes, benzylidene dyes and monomethine oxonol dyes having an open chain active methylene compound as a coupling component; quinone-based dyes such as naphthoquinone dyes and anthraquinone dyes; quinophthalone dyes; nitro and nitroso dyes; acridine dyes; and acridinone dyes.

Examples of the magenta dye include aryl or heteryl azo dyes having a phenol, a naphthol, an aniline, a pyrazolone, a pyridone, a pyrazolotriazole, a closed ring active methylene compound or a heterocyclic ring (e.g. pyrrole, imidazole, thiophene or thiazole derivative) as a coupling component; methine dyes such as azomethine dyes, arylidene dyes, styryl dyes, merocyanine dyes and oxonol dyes having a pyrazolone or a pyrazolotriazole as a coupling component; carbonium dyes such as diphenylmethane dyes, triphenylmethane dyes and xanthene dyes; quinone-based dyes such as naphthoquinone, anthraquinone and anthrapyridone; and fused polycyclic dyes such as dioxazine dyes.

Examples of the cyan dye include azomethine dyes such as indoaniline dyes and indophenol dyes; polymethine dyes such as cyanine dyes, oxonol dyes and merocyanine dyes, carbonium dyes such as diphenylmethane dyes, triphenylmethane dyes and xanthene dyes; phthalocyanine dyes; anthraquinone dyes; aryl or heteryl azo dyes (e.g. C.I. Direct Blue 14) having a phenol, a naphthol, an aniline, or a pyrrolopyrimidinone or pyrrolotriazinone derivative as a coupling component; and indigo thioindigo dyes.

From the viewpoint of image sharpness of the coating film, the particle diameter of the colorant (Ja) is preferably 0.01 µm to 2.0 µm, more preferably 0.01 µm to 1.0 µm in terms of an average particle diameter.

The addition amount of the colorant (Ja) is not particularly limited, but is preferably 1 to 60% by weight based on the total weight of the photosensitive composition.

When a pigment is used, it is preferable to add a pigment dispersant for improving dispersibility of the pigment and storage stability of the photosensitive composition.

Examples of the pigment dispersant include pigment dispersants (e.g. Anti-Terra-U, Disperbyk-101, 103, 106, 110, 161, 162, 164, 166, 167, 168, 170, 174, 182, 184 and 2020) manufactured by BYK Japan K.K.; pigment dispersants (e.g. AJISPER PB 711, PB 821, PB 814, PN 411 and PA 111) manufactured by Ajinomoto Fine-Techno Co., Inc.; and pigment dispersants (e.g. SOLSPERSE 5000, 12000, 32000, 33000 and 39000) manufactured by The Lubrizol Corporation. One of these pigment dispersants may be used alone, or two or more thereof may be used in combination. The addition amount of the pigment dispersant is not particularly limited, but it is preferable that the pigment dispersant is used in an amount ranging from 0.1 to 10% by weight in the photosensitive composition.

When the photosensitive composition of the present invention contains metal oxide particles (Jb) or metal particles (Jc), for example, the photosensitive composition can be used for formation of a green sheet of a ceramic electronic component and formation of an electrode layer.

The metal oxide particles (Jb) are used in formation of a dielectric layer. Examples of the metal oxide particles (Jb) include those of titanium oxide, aluminum oxide, barium titanate, calcium zirconate, niobium oxide and lead zirconate titanate, and with barium titanate being preferable. Aluminum oxide, silicon oxide, titanium oxide or the like is used in formation of a coating layer for protecting a base material.

From the viewpoint of a dielectric constant, the particle diameter of the metal oxide particles (Jb) is preferably 0.01 µm to 2.0 µm, more preferably 0.01 µm to 1.0 µm in terms of an average particle diameter.

The metal powder (Jc) is a noble metal or base metal that is used in formation of a conductor layer, and specific examples thereof include palladium, nickel, copper, silver and gold, with palladium, nickel and copper being preferable.

The average particle diameter of the metal powder (Jc) is preferably 0.01 µm to 10 µm.

The photosensitive composition of the present invention may contain a solvent, an adhesion imparting agent (e.g. silane coupling agent) and the like as necessary.
Examples of the solvent include glycol ethers (e.g. ethylene glycol monoalkyl ethers and propylene glycol monoalkyl ethers), ketones (e.g. acetone, methyl ethyl ketone, methyl isobutyl ketone and cyclohexanone), esters (e.g. ethyl acetate, butyl acetate, ethylene glycol alkyl ether acetates and propylene glycol alkyl ether acetates), aromatic hydrocarbons (e.g. toluene, xylene, mesitylene and limonene), alcohols (e.g. methanol, ethanol, normal propanol, isopropanol, butanol, geraniol, linalool and citronellol), and ethers (e.g. tetrahydrofuran and 1,8-cineol). One of these solvents may be used alone, or two or more thereof may be used in combination.

The content of the solvent in the photosensitive composition is preferably 0 to 99% by weight, more preferably 3 to 95% by weight, especially preferably 5 to 90% by weight based on the total weight of the photosensitive composition.

Examples of the adhesion imparting agent include γ-aminopropyltrimethoxysilane, γ-aminopropyltriethoxysilane, vinyltriethoxysilane, γ-glycidoxypropyltriethoxysilane, γ-methacryloxypropyltrimethoxysilane, urea propyltriethoxysilane, tris(acetylacetonate)aluminum and acetylacetate aluminum diisopropylate. When the adhesion imparting agent is used, the content thereof is preferably 0 to 20% by weight, more preferably 1 to 15% by weight, especially preferably 5 to 10% by weight based on the total weight of the photosensitive composition.

The photosensitive composition of the present invention may further contain inorganic fine particles, a dispersant, a defoaming agent, a leveling agent, a thixotropy imparting agent, a slip agent, a flame retardant, an antistatic agent, an antioxidant and an ultraviolet absorbent and the like according to a use purpose.

The photosensitive composition of the present invention is obtained by, for example, a method in which an onium salt represented by the general formula (1), the radical-polymerizable compound (C), the sensitizer (B), the colorant (Ja) to be used as necessary, the metal oxide particles (Jb) to be used as necessary, the metal particles (Jc) to be used as necessary, a solvent to be used as necessary, and an adhesion imparting agent to be used as necessary are homogeneously mixed using a stirring and mixing apparatus (e.g. mixing container or paint shaker with a stirrer), or kneaded using a known kneader (e.g. ball mill or three-roll mill). The uniform-mixing temperature and the kneading temperature are normally 10°C to 40°C, preferably 20°C to 30°C.

The photosensitive composition of the present invention contains the sensitizer (B) which absorbs light having a wavelength in a near-infrared region (700 nm to 1200 nm), so that the onium salt (A) is decomposed by energy or electron transfer.

The present invention is characterized in that the sensitizer (B) is a polymethine-based dye selected from the following compounds of chemical formula 5 or chemical formula 6.

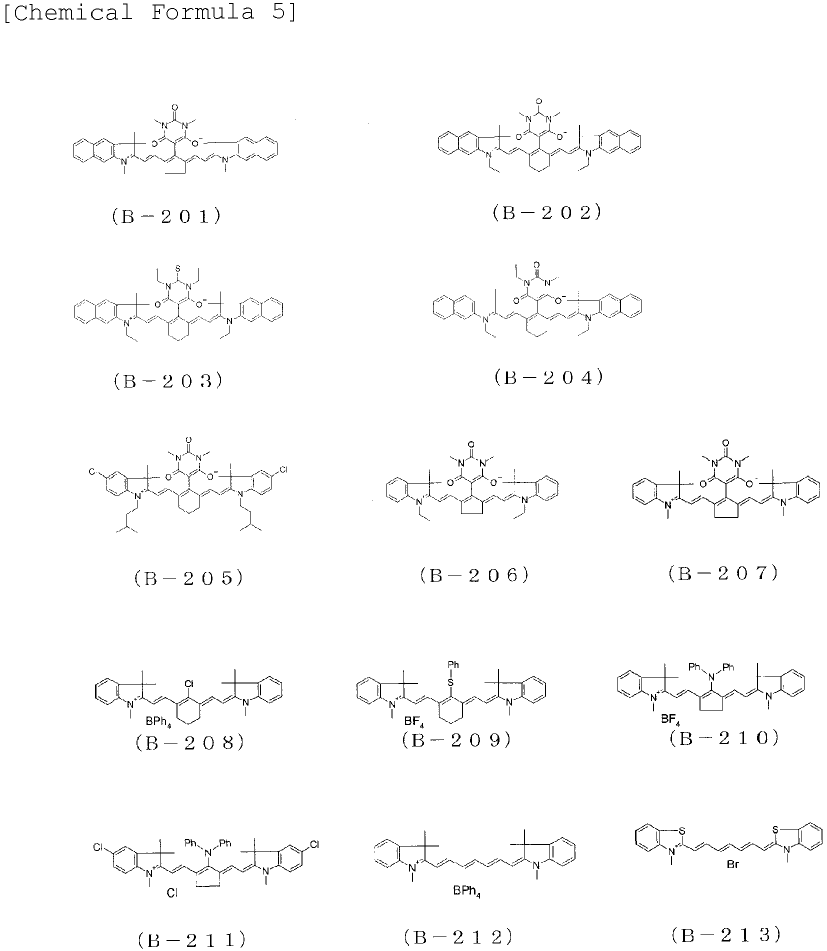

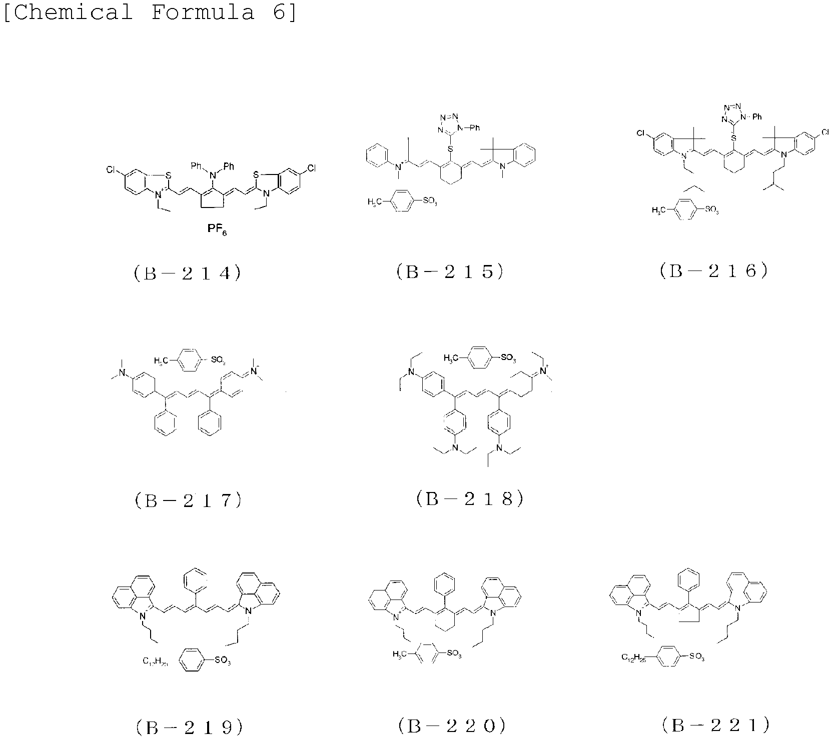

One of these sensitizers (B) may be used alone, or two or more thereof may be used in combination. In addition, the content of the sensitizer (B) is normally 0.005 to 20% by weight, preferably 0.01 to 10% by weight based on the total weight of the sensitizer (B), the onium salt and the radical-polymerizable compound (C).

For the photosensitive composition of the present invention, a light source can be used which includes an argon ion laser, a helium cadmium laser, a helium neon laser, a krypton ion laser, various kinds of semiconductor lasers, a xenon lamp or an LED light source, and is capable of radiating an energy ray in a near-infrared region having a wavelength of 700 nm to 1200 nm. Depending on a use, a high-pressure mercury lamp that is commonly used, as well as an ultra-high-pressure mercury lamp, a metal halide lamp and a high power metal halide lamp can be used because an energy ray is generated even at a wavelength of 700 nm or more.

When irradiated with light, the photosensitive composition of the present invention can generate radicals, so that a curing reaction can be accelerated to obtain a cured product. Therefore, it is preferable that a method for producing such a cured product includes a step of radiating light to the photosensitive composition containing the sensitizer (B) selected according to a wavelength of light serving as a light source, or radiating light using a light source corresponding to the absorption wavelength of the sensitizer (B) used. In the curing reaction, heating may be performed as necessary. The heating temperature is normally 30°C to 200°C, preferably 35°C to 150°C, more preferably 40°C to 120°C.

As a method for applying the photosensitive composition of the present invention to a base material, a known coating method such as spin coating, roll coating or spray coating, as well as a known printing method such as lithographic printing, carton printing, metal printing, offset printing, screen printing or gravure printing can be used. The photosensitive composition can be also applied by inkjet-type coating in which fine droplets are continuously discharged.

### EXAMPLES

Hereinafter, the present invention is more specifically described with reference to examples, which however are not intended to limit the invention. "%" means "% by weight" unless otherwise specified.

### Production Example 1 Synthesis of potassium tris(nonafluorobutyl)trifluorophosphate (AN-1)

Tris(nonafluorobutyl)difluorophosphorane (gas chromatography purity: 90%, yield: 60%) was synthesized by electrolytic fluorination of tributylphosphine in accordance with a patent document (US Patent No. 6264818). Potassium fluoride of 18.0 g and dimethoxyethane of 600 ml were added in a 1L reaction vessel, the mixture was stirred and suspended, and 202.6 g of the obtained tris(nonafluorobutyl)difluorophosphorane was added dropwise while the liquid was kept at a temperature of 20 to 30°C. The mixture was stirred at room temperature for 24 hours, the reaction liquid was then filtered, and dimethoxyethane was distilled off from the filtrate under reduced pressure to obtain 136.0 g of a white powder. From ¹⁹F and ³¹P-NMR, this white powder was confirmed to be potassium tris(nonafluorobutyl)trifluorophosphate (AN-1).

### Production Example 2 Synthesis of potassium tris(heptafluoropropyl)trifluorophosphate (AN-2)

Tris(heptafluoropropyl)difluorophosphorane (gas chromatography purity: 89%, yield: 52%) was synthesized by electrolytic fluorination of tripropylphosphine in accordance with a patent document (US Patent No. 6264818). Except that 161.0 g of tris(heptafluoropropyl)difluorophosphorane was used in place of 202.6 g of tris(nonafluorobutyl)difluorophosphorane in Production Example 1, the same procedure as in Production Example 1 was carried out to obtain potassium tris(heptafluoropropyl)trifluorophosphate (AN-2).

### Production Example 3 Synthesis of potassium tris(pentafluoroethyl)trifluorophosphate (AN-3)

Tris(pentafluoroethyl)difluorophosphorane (gas chromatography purity: 97%, yield: 72%) was synthesized by electrolytic fluorination of triethylphosphine in accordance with a patent document (US Patent No. 6264818). Except that 119.0 g of tris(heptafluoroethyl)difluorophosphorane was used in place of 202.6 g of tris(nonafluorobutyl)difluorophosphorane in Production Example 1, the same procedure as in Production Example 1 was carried out to obtain potassium tris(pentafluoroethyl)trifluorophosphate (AN-3).

### Production Example 4 Synthesis of potassium tris(nonafluoroisobutyl)trifluorophosphate (AN-4)

Tris(nonafluoroisobutyl)difluorophosphorane (gas chromatography purity: 89%, yield: 47%) was synthesized by electrolytic fluorination of triisobutylphosphine in accordance with a patent document (US Patent No. 6264818). Except that 202.6 g of tris(nonafluoroisobutyl)difluorophosphorane was used in place of 202.6 g of tris(nonafluorobutyl)difluorophosphorane in Production Example 1, the same procedure as in Production Example 1 was carried out to obtain potassium tris(nonafluoroisobutyl)trifluorophosphate (AN-4).

### Production Example 5 Synthesis of potassium tris(heptafluoroisopropyl)trifluorophosphate (AN-5)

Tris(heptafluoroisopropyl)difluorophosphorane (gas chromatography purity: 89%, yield: 43%) was synthesized by electrolytic fluorination of triisopropylphosphine in accordance with a patent document (US Patent No. 6264818). Except that 161.0 g of tris(heptafluoroisopropyl)difluorophosphorane was used in place of 202.6 g of tris(nonafluorobutyl)difluorophosphorane in Production Example 1, the same procedure as in Production Example 1 was carried out to obtain potassium tris(heptafluoroisopropyl)trifluorophosphate (AN-5).

### Production Example 6 Synthesis of sodium bis(heptafluoropropyl)tetrafluorophosphate (AN-6)

Bis(heptafluoropropyl)tetrafluorophosphorane (gas chromatography purity: 90%, yield: 53%) was synthesized by electrolytic fluorination of dipropylchlorophosphine in accordance with a patent document (US Patent No. 6264818). Then, 16.1 g of sodium fluoride and 600 ml of dimethoxyethane were added in a 1L reaction vessel, the mixture was stirred and suspended, and 119.0 g of the obtained bis(heptafluoropropyl)tetrafluorophosphorane was added dropwise while the liquid is kept at a temperature of 20 to 30°C. The mixture was stirred at room temperature for 24 hours, the reaction liquid was then filtered, and dimethoxyethane was distilled off from the filtrate under reduced pressure to obtain 115.5 g of a white powder. From ¹⁹F and ³¹P-NMR, this white powder was confirmed to be sodium bis(heptafluoropropyl)tetrafluorophosphate (AN-6).

### Production Example 7 Synthesis of sodium bis(pentafluoroethyl)tetrafluorophosphate (AN-7)

Bis(pentafluoroethyl)trifluorophosphorane (gas chromatography purity: 96%, yield: 68%) was synthesized by electrolytic fluorination of diethylchlorophosphine in accordance with a patent document (US Patent No. 6264818). Except that 91.0 g of bis(pentafluoroethyl)trifluorophosphorane was used in place of 119.0 g of bis(heptafluoropropyl)tetrafluorophosphorane in Production Example 6, the same procedure as in Production Example 6 was carried out to obtain sodium bis(pentafluoroethyl)tetrafluorophosphate (AN-7).

### Production Example 8 Synthesis of sodium bis(nonafluorobutyl)tetrafluorophosphate (AN-8)

Bis(nonafluorobutyl)trifluorophosphorane (gas chromatography purity: 77%, yield: 67%) was synthesized by electrolytic fluorination of dibutylchlorophosphine in accordance with a patent document (US Patent No. 6264818). Except that 146.8 g of bis(nonafluorobutyl)trifluorophosphorane was used in place of 119.0 g of bis(heptafluoropropyl)tetrafluorophosphorane in Production Example 6, the same procedure as in Production Example 6 was carried out to obtain sodium bis(nonafluorobutyl)tetrafluorophosphate (AN-8).

### Production Example 9 Synthesis of lithium (nonafluorobutyl)pentafluorophosphate (AN-9)

(Nonafluorobutyl)tetrafluorophosphorane (gas chromatography purity: 90%, yield: 53%) was synthesized by electrolytic fluorination of butyldichlorophosphine in accordance with a patent document (US Patent No. 6264818). Then, 8.1 g of lithium fluoride and 600 ml of dimethoxyethane were added in a 1L reaction vessel, the mixture was stirred and suspended, and 91.0 g of the obtained (nonafluorobutyl)tetrafluorophosphorane was added dropwise while the liquid was kept at a temperature of 20 to 30°C. The mixture was stirred at room temperature for 24 hours, the reaction liquid was then filtered, and dimethoxyethane was distilled off from the filtrate under reduced pressure to obtain 87.0 g of a white powder. From ¹⁹F and ³¹P-NMR, this white powder was confirmed to be lithium (nonafluorobutyl)pentafluorophosphate (AN-9).

### Production Example 10 Synthesis of lithium (pentafluoroethyl)pentafluorophosphate (AN-10)

(Pentafluoroethyl)tetrafluorophosphorane (gas chromatography purity: 90%, yield: 53%) was synthesized by electrolytic fluorination of dichloroethylphosphine in accordance with a patent document (US Patent No. 6264818). Then, 8.1 g of lithium fluoride and 600 ml of dimethoxyethane were added in a 1L reaction vessel, the mixture was stirred and suspended, and 63.0 g of the obtained (nonafluorobutyl)tetrafluorophosphorane was added dropwise while the liquid was kept at a temperature of 20 to 30°C. The mixture was stirred at room temperature for 24 hours, the reaction liquid was then filtered, and dimethoxyethane was distilled off from the filtrate under reduced pressure to obtain 57.0 g of a white powder. From ¹⁹F and ³¹P-NMR, this white powder was confirmed to be lithium (pentafluoroethyl)pentafluorophosphate (AN-10).

### Production Example 11 Synthesis of onium salt (A1-1): diphenyliodonium tris(nonafluorobutyl)trifluorophosphate

Added in a reaction vessel were 4.3 g of diphenyliodonium trifluoromethanesulfonate (manufactured by Tokyo Chemical Industry Co., Ltd.) and 30 g of dichloromethane. The potassium salt (AN-1) of 8.0 g synthesized in Production Example 1 was added while the mixture was stirred, 50 mL of water was further added, and the mixture was stirred at room temperature for 18 hours. The mixture was left standing, the aqueous layer was then removed by liquid separation, and the organic layer was washed with 50 mL of water five times. The organic solvent was distilled off under reduced pressure to obtain 9.7 g of a white solid. From ¹H, ¹⁹F and ³¹P-NMR, this white solid was confirmed to be an onium salt (A1-1).

### Production Example 12 Synthesis of onium salt (A1-2): di(tert-butylphenyl)iodonium tris(nonafluorobutyl)trifluorophosphate

Except that 5.4 g of di(tert-butylphenyl)iodoniumhexafluorophosphate (manufactured by Tokyo Chemical Industry Co., Ltd.) was used in place of 4.3 g of diphenyliodonium trifluoromethanesulfonate in Production Example 11, the same procedure as in Production Example 11 was carried out to obtain 10.9 g of a desired product. From ¹H, ¹⁹F and ³¹P-NMR, this white solid was confirmed to be an onium salt (A1-2).

### Production Example 13 Synthesis of onium salt (A1-3): (4-isopropylphenyl)tolyliodonium tris(nonafluorobutyl)trifluorophosphate

Added in a reaction vessel was 20 g of 4-methyliodobenzene, and dissolved by adding 50 mL of acetic acid and 10 mL of sulfuric acid, and while the solution was cooled in an ice-water bath, 10 g of potassium persulfate was gradually added at 15°C or lower. The mixture was reacted at 20°C for 4 hours, and 24.4 g of cumene was added dropwise thereinto at a temperature of not higher than 20°C. Thereafter, the mixture was reacted at room temperature for 20 hours. The reaction liquid was poured into a solution obtained by dissolving 80 g of the potassium salt (AN-1) in 500 mL of water, and the mixture was further stirred for 3 hours. Dichloromethane of 500 mL was added thereto. The mixture was left standing, the aqueous layer was then removed by liquid separation, and the organic layer was washed with 100 mL of water five times. The dichloromethane was concentrated, and recrystallized from cyclohexane to obtain 95 g of a white solid. From ¹H, ¹⁹F and ³¹P-NMR, this white solid was confirmed to be an onium salt (A1-3).

### Production Example 14 Synthesis of onium salt (A1-4): (4-isopropylphenyl)tolyliodonium tris(pentafluoroethyl)trifluorophosphate

Except that 45 g of the potassium salt (AN-3) was used in place of 80 g of the potassium salt (AN-1) in Production Example 13, the same procedure as in Production Example 13 was carried out to obtain a desired product. From ¹H, ¹⁹F and ³¹P-NMR, this product was confirmed to be an onium salt (A1-4).

### Production Example 15 Synthesis of onium salt (A1-5): (4-isopropylphenyl)tolyliodonium tris(heptafluoroisopropyl) trifluorophosphate

Except that 60 g of the potassium salt (AN-5) was used in place of 80 g of the potassium salt (AN-1) in Production Example 13, the same procedure as in Production Example 13 was carried out to obtain a desired product. From ¹H, ¹⁹F and ³¹P-NMR, this product was confirmed to be an onium salt (A1-5).

### Production Example 16 Synthesis of onium salt (A1-6): di (tert-butylphenyl)iodonium bis(pentafluoroethyl)tetrafluorophosphate

Except that 3.6 g of the sodium salt (AN-7) was used in place of 8.0 g of the potassium salt (AN-1) in Production Example 12, the same procedure as in Production Example 12 was carried out to obtain a desired product. From ¹H, ¹⁹F and ³¹P-NMR, this product was confirmed to be an onium salt (A1-6).

### Production Example 17 Synthesis of onium salt (A1-7): di(tert-butylphenyl)iodonium bis(heptafluoropropyl)tetrafluorophosphate

Except that 4.5 g of the sodium salt (AN-6) was used in place of 8.0 g of the potassium salt (AN-1) in Production Example 12, the same procedure as in Production Example 12 was carried out to obtain a desired product. From ¹H, ¹⁹F and ³¹P-NMR, this product was confirmed to be an onium salt (A1-7).

### Production Example 18 Synthesis of onium salt (A1-8): (4-octyloxyphenyl)phenyliodonium tris(nonafluoroisobutyl)trifluorophosphate

A desired product was obtained in accordance with the method described in a patent document (JP-A-06-184170). From ¹H, ¹⁹F and ³¹P-NMR, this product was confirmed to be an onium salt (A1-8).

### Production Example 19 Synthesis of onium salt (A1-9): di(tert-butylphenyl)iodonium (nonafluorobutyl)pentafluorophosphate

Except that 4.0 g of the lithium salt (AN-9) was used in place of 8.0 g of the potassium salt (AN-1) in Production Example 12, the same procedure as in Production Example 12 was carried out to obtain a desired product. From ¹H, ¹⁹F and ³¹P-NMR, this product was confirmed to be an onium salt (A1-9).

### Production Example 20 Synthesis of onium salt (A1-10): di(tert-butylphenyl)iodonium (pentafluoroethyl)pentafluorophosphate

Except that 2.6 g of the lithium salt (AN-10) was used in place of 8.0 g of the potassium salt (AN-1) in Production Example 12, the same procedure as in Production Example 12 was carried out to obtain a desired product. From ¹H, ¹⁹F and ³¹P-NMR, this product was confirmed to be an onium salt (A1-10).

### Production Example 21 Synthesis of onium salt (A2-1): triphenylsulfonium tris(nonafluorobutyl)trifluorophosphate

Added in a reaction vessel were 3.4 g of triphenylsulfonium bromide (manufactured by Tokyo Chemical Industry Co., Ltd.) and 50 mL of dichloromethane. The potassium salt of 8.0 g (AN-1) synthesized in Production Example 1 was added while the mixture was stirred, 50 mL of water was further added, and the mixture was stirred at room temperature for 8 hours. The mixture was left standing, the aqueous layer was then removed by liquid separation, and the organic layer was washed with 50 mL of water five times. The organic solvent was distilled off under reduced pressure to obtain 9.2 g of a white solid. From ¹H, ¹⁹F and ³¹P-NMR, this white solid was confirmed to be an onium salt (A2-1).

### Production Example 22 Synthesis of onium salt (A2-2): tris(4-fluorophenyl)sulfonium tris(heptafluoropropyl)trifluorophosphate

Bis(4-fluorophenyl)sulfoxide of 23.8 g was added in a reaction vessel, and 200 mL of THF was added. The mixture was cooled to 0°C in an ice bath, and 50 g of trimethylsilyl chloride was added dropwise thereto. The mixture was stirred for 2 hours, and while the mixture was kept at 10°C or lower, 250 mL of a 1.0 mol/L THF solution prepared from 4-fluorobromobenzene by a normal method was added dropwise. After completion of the dropwise addition, the mixture was reacted at room temperature for 8 hours. The reaction liquid was poured into 1 L of water, and washed with 500 mL of toluene twice. The potassium salt of 65 g (AN-2) was added to the aqueous layer, and the mixture was further stirred for 4 hours. Dichloromethane of 700 mL was added, the aqueous layer was removed by liquid separation, and washing was performed with 500 mL of water five times. The dichloromethane layer was concentrated, and crystallized with cyclohexane to obtain 88 g of a white solid. From ¹H, ¹⁹F and ³¹P-NMR, this white solid was confirmed to be an onium salt (A2-2).

### Production Example 23 Synthesis of onium salt (A2-3): (4-phenylthio)phenyldiphenylsulfonium tris(pentafluoroethyl)trifluorophosphate

A desired product was obtained in accordance with the method described in a patent document (WO 2005-116038). From ¹H, ¹⁹F and ³¹P-NMR, this product was confirmed to be an onium salt (A2-3).

### Production Example 24 Synthesis of onium salt (A2-4): thiodi-p-phenylene bis(diphenylsulfonium)bis[tris(heptafluoroisopropyl)trifluo rophosphate]

A desired product was obtained in accordance with the method described in a patent document (JP-A-2013-227368). From ¹H, ¹⁹F and ³¹P-NMR, this product was confirmed to be an onium salt (A2-4).

### Production Example 25 Synthesis of onium salt (A2-5): (4-phenylthio)phenyldiphenylsulfonium tris(nonafluoroisobutyl)trifluorophosphate

A desired product was obtained in accordance with the method described in a patent document (WO 2005-116038). From ¹H, ¹⁹F and ³¹P-NMR, this product was confirmed to be an onium salt (A2-5).

### Production Example 26 Synthesis of onium salt (A2-6): tris(4-tert-butylphenyl)sulfonium bis(pentafluoroethyl)tetrafluorophosphate

Added in a reaction vessel were 5.8 g of tris(4-tert-butylphenyl)sulfonium triflate (manufactured by Aldrich) and 50 mL of dichloromethane. The sodium salt of 3.9 g (AN-7) synthesized in Production Example 7 was added while the mixture was stirred, 50 mL of water was further added, and the mixture was stirred at room temperature for 8 hours. The mixture was left standing, the aqueous layer was then removed by liquid separation, and the organic layer was washed with 50 mL of water five times. The organic solvent was distilled off under reduced pressure to obtain 6.2 g of a white solid. From ¹H, ¹⁹F and ³¹P-NMR, this white solid was confirmed to be an onium salt (A2-6).

### Production Example 27 Synthesis of onium salt (A2-7): tris(4-tert-butylphenyl)sulfonium bis(nonafluorobutyl)tetrafluorophosphate

Except that 6.0 g of the sodium salt (AN-8) was used in place of 3.9 g of the sodium salt (AN-7) in Production Example 26, the same procedure as in Production Example 26 was carried out to obtain a desired product. From ¹H, ¹⁹F and ³¹P-NMR, this product was confirmed to be an onium salt (A2-7).

### Production Example 28 Synthesis of onium salt (A2-8): tris(4-fluorophenyl)sulfonium (nonafluorobutyl)pentafluorophosphate

Except that 35 g of the lithium salt (AN-9) was used in place of 65 g of the potassium salt (AN-2) in Production Example 22, the same procedure as in Production Example 22 was carried out to obtain a desired product. From ¹H, ¹⁹F and ³¹P-NMR, this product was confirmed to be an onium salt (A2-8).

### Production Example 29 Onium salt (A2-9): Synthesis of tris(4-fluorophenyl)sulfonium (pentafluoroethyl)pentafluorophosphate

Except that 25 g of the lithium salt (AN-10) was used in place of 65 g of the potassium salt (AN-2) in Production Example 22, the same procedure as in Production Example 22 was carried out to obtain a desired product. From ¹H, ¹⁹F and ³¹P-NMR, this product was confirmed to be an onium salt (A2-9).

### Comparative Production Example 1 Synthesis of onium salt (A'-1) below

Except that 3.5 g of the tetraphenyl borate sodium (manufactured by NACALAI TESQUE, INC.) was used in place of 8.0 g of the potassium salt (AN-1) in Production Example 12, the same procedure as in Production Example 12 was carried out to obtain a desired product. From ¹H-NMR, this product was confirmed to be an onium salt (A'-1).

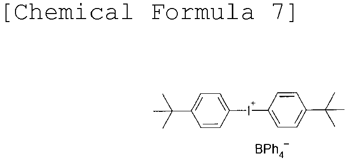

### Comparative Production Example 2 Synthesis of onium salt (A'-2) below

Except that 3.5 g of the tetraphenyl borate sodium (manufactured by NACALAI TESQUE, INC.) was used in place of 8.0 g of the potassium salt (AN-1) in Production Example 21, the same procedure as in Production Example 21 was carried out to obtain a desired product. From ¹H-NMR, this product was confirmed to be an onium salt (A'-2).

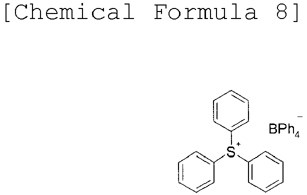

### <Examples 1 to 34 and Comparative Examples 1 to 16> [Preparation of photosensitive composition]

The radical-polymerizable compound (C) of 100 g, the onium salt (A) of 3 g and the sensitizer (B) of 0.3 g were homogeneously mixed to prepare photosensitive compositions (Q-1) to (Q-34) of the present invention, and comparative photosensitive compositions (Q'-1) to (Q'-16). The types of raw materials used are shown in Table 1. This photosensitive composition was applied to a glass substrate (76 mm × 52 mm) using an applicator (40 µm), and exposed to light using an irradiator LIGHTNINGCURE Spot Light Source LC 8 (manufactured by Hamamatsu Photonics K.K.) as a light source, and curability was examined by the following evaluation method. The results are shown in Table 1.

### [Raw materials used]

A1-1 to A2-9 (onium salt described above)
A'-1: onium salt in Comparative Production Example 1
A'-2: Onium salt in Comparative Production Example 2
A'-3: di(tert-butylphenyl)iodonium hexafluorophosphate (manufactured by Tokyo Chemical Industry Co., Ltd.)
A'-4: triphenylsulfonium bromide (manufactured by Tokyo Chemical Industry Co., Ltd.)
B-1: B-201 (described above as a specific example of a polymethine dye)
B-2: B-204 (described above as a specific example of a polymethine dye)
B-3: 3,3'-carbonylbis(7-diethylaminocoumarin)
C-1: dipentaerythritol pentaacrylate ("NEOMER DA-600" manufactured by Sanyo Chemical Industries, Ltd.)
C-2: ethoxylated trimethylolpropane triacrylate ("NEOMER TA-401" manufactured by Sanyo Chemical Industries, Ltd.)
C-3: polypropylene glycol diacrylate ("NEOMER PA-305" manufactured by Sanyo Chemical Industries, Ltd.)

### [Curability]

Curability-1: the composition was exposed to light through an infrared transmission filter R72 (cutting light having a wavelength of 700 nm or less) (manufactured by HOYA CORPORATION) to examine curability.

### Evaluation of curability:

⊙ The surface has no tackiness, and is not scratched even when scraped with a nail.
O The surface has no tackiness, but is scratched with a nail.
△ The surface remains tacky.
× The composition remains liquid, and is not cured.

**[Table 1]**

| | | Photosensitiv e composition | Onium salt (A) | Sensitizer (B) | Radical-polymerizabl e compound (C) | Curabilit y-1 |
|---|---|---|---|---|---|---|
| Example | 1 | Q-1 | A1-1 | B-1 | C-1 | ⊙ |
| | 2 | Q-2 | A1-2 | B-1 | C-1 | ⊙ |
| | 3 | Q-3 | A1-3 | B-1 | C-1 | ⊙ |
| | 4 | Q-4 | A1-4 | B-1 | C-1 | ⊙ |
| | 5 | Q-5 | A1-5 | B-1 | C-1 | ⊙ |
| | 6 | Q-6 | A1-6 | B-1 | C-1 | ⊙ |
| | 7 | Q-7 | A1-7 | B-1 | C-1 | ⊙ |
| | 8 | Q-8 | A1-8 | B-1 | C-1 | ⊙ |
| | 9 | Q-9 | A1-9 | B-1 | C-1 | ⊙ |
| | 10 | Q-10 | A1-10 | B-1 | C-1 | ⊙ |
| | 11 | Q-11 | A2-1 | B-1 | C-1 | ⊙ |
| | 12 | Q-12 | A2-2 | B-1 | C-1 | ⊙ |
| | 13 | Q-13 | A2-3 | B-1 | C-1 | ⊙ |
| | 14 | Q-14 | A2-4 | B-1 | C-1 | ⊙ |
| | 15 | Q-15 | A2-5 | B-1 | C-1 | ⊙ |
| | 16 | Q-16 | A2-6 | B-1 | C-1 | ⊙ |
| | 17 | Q-17 | A2-7 | B-1 | C-1 | ⊙ |
| | 18 | Q-18 | A2-8 | B-1 | C-1 | ⊙ |
| | 19 | Q-19 | A2-9 | B-1 | C-1 | ⊙ |
| | 20 | Q-20 | A1-2 | B-1 | C-2 | ⊙ |
| | 21 | Q-21 | A1-3 | B-1 | C-2 | ⊙ |
| | 22 | Q-22 | A1-4 | B-1 | C-2 | ⊙ |
| | 23 | Q-23 | A2-3 | B-1 | C-2 | ⊙ |
| | 24 | Q-24 | A2-9 | B-1 | C-2 | ⊙ |
| | 25 | Q-25 | A1-2 | B-1 | C-3 | ⊙ |
| | 26 | Q-26 | A1-3 | B-1 | C-3 | ⊙ |
| | 27 | Q-27 | A1-4 | B-1 | C-3 | ⊙ |
| | 28 | Q-28 | A2-3 | B-1 | C-3 | ⊙ |
| | 29 | Q-29 | A2-9 | B-1 | C-3 | ⊙ |
| | 30 | Q-30 | A1-2 | B-2 | C-1 | ⊙ |
| | 31 | Q-31 | A1-3 | B-2 | C-1 | ⊙ |
| | 32 | Q-32 | A1-4 | B-2 | C-1 | ⊙ |
| | 33 | Q-33 | A2-3 | B-2 | C-1 | ⊙ |
| | 34 | Q-34 | A2-9 | B-2 | C-1 | ⊙ |
| Comparative Example | 1 | Q'-1 | A'-1 | B-1 | C-1 | ○ |
| | 2 | Q'-2 | A'-2 | B-1 | C-1 | Δ |
| | 3 | Q'-3 | A'-3 | B-1 | C-1 | ○ |
| | 4 | Q'-4 | A'-4 | B-1 | C-1 | × |
| | 5 | Q'-5 | A'-1 | B-1 | C-2 | ○ |
| | 6 | Q'-6 | A'-2 | B-1 | C-2 | Δ |
| | 7 | Q'-7 | A'-3 | B-1 | C-2 | ○ |
| | 8 | Q'-8 | A'-4 | B-1 | C-2 | × |
| | 9 | Q'-9 | A'-1 | B-1 | C-3 | ○ |
| | 10 | Q'-10 | A'-2 | B-1 | C-3 | Δ |
| | 11 | Q'-11 | A'-3 | B-1 | C-3 | ○ |
| | 12 | Q'-12 | A'-4 | B-1 | C-3 | × |
| | 13 | Q'-13 | A'-1 | B-2 | C-1 | ○ |
| | 14 | Q'-14 | A'-2 | B-2 | C-1 | Δ |
| | 15 | Q'-15 | A'-3 | B-2 | C-1 | ○ |
| | 16 | Q'-16 | A'-4 | B-2 | C-1 | × |

### <Examples 35 to 39 (Reference Examples) and Comparative Examples 17 to 20>

### [Preparation of photosensitive composition]

The radical-polymerizable compound (C) of 100 g, the onium salt (A)of 3 g and the sensitizer (B-3) of 0.3 g were homogeneously mixed to prepare photosensitive compositions (Q-35) to (Q-39) of the present invention, and comparative photosensitive compositions (Q'-17) to (Q'-20). The types of raw materials used are shown in Table 1. This photosensitive composition was applied to a glass substrate (76 mm × 52 mm) using an applicator (40 µm), and exposed to light using an irradiator LIGHTNINGCURE Spot Light Source LC 8 (manufactured by Hamamatsu Photonics K.K.) as a light source, and curability was examined by the following evaluation method. The results are shown in Table 2. The raw materials used are as described above.

### [Curability]

Curability-2: the composition was exposed to light through a sharp-cut filter Y44 (cutting light having a wavelength of 430 nm or less) (manufactured by HOYA CORPORATION) to examine curability.

### Evaluation of curability:

⊙ The surface has no tackiness, and is not scratched even when scraped with a nail.
O The surface has no tackiness, but is scratched with a nail.
△ The surface remains tacky.
× The composition remains liquid, and is not cured.

**[Table 2]**

| | | Photosensitive composition | Onium salt (A) | Sensitizer (B) | Radical-polymerizable compound (C) | Curability-2 |
|---|---|---|---|---|---|---|
| Example | 35 | Q-35 | A1-2 | B-3 | C-3 | ⊙ |
| | 36 | Q-36 | A1-3 | B-3 | C-3 | ⊙ |
| | 37 | Q-37 | A1-4 | B-3 | C-3 | ⊙ |
| | 38 | Q-38 | A2-3 | B-3 | C-3 | ⊙ |
| | 39 | Q-39 | A2-9 | B-3 | C-3 | ⊙ |
| Comparative Example | 17 | Q'-17 | A'-1 | B-3 | C-3 | ○ |
| | 18 | Q'-18 | A'-2 | B-3 | C-3 | Δ |
| | 19 | Q'-19 | A'-3 | B-3 | C-3 | ○ |
| | 20 | Q'-20 | A'-4 | B-3 | C-3 | × |

It is apparent from Table 1 that the photosensitive composition of the present invention is more sensitive than the comparative photosensitive composition. In addition, it is apparent that selection of a sensitizer appropriate to the wavelength of light to be radiated is important.

### <Examples 40 to 44 and Comparative Examples 21 to 24: Examples of photosensitive compositions containing pigment>

### [Preparation of photosensitive composition]

### <Preparation of high-concentration dispersion (1)>

A mixture including 43 parts of titanium oxide ("TIPAQUE R-930" manufactured by Ishihara Sangyo Kaisha, Ltd.) as a pigment, 4 parts of a pigment dispersant ("SOLSPERSE 32000" manufactured by The Lubrizol Corporation) and 53 parts of tetrahydrofurryl acrylate "LIGHT ACRYLATE THF-A" manufactured by Kyoeisha Chemical Co., Ltd.) as a radical-polymerizable compound (C) was kneaded with a ball mill for 3 hours to prepare a pigment dispersant liquid having a pigment concentration of 43%.

### <Preparation of photosensitive composition>

Said high-concentration pigment dispersant liquid of 47 parts, dipentaerythritol pentaacrylate of 46 parts ("NEOMER DA-600" manufactured by Sanyo Chemical Industries, Ltd.), 0.5 parts of the sensitizer (B-2), and 5 parts of the onium salt (A) or 5 parts of the comparative onium salt (A') as shown in Table 2 were kneaded at 25°C for 3 hours with a ball mill to produce photosensitive compositions (Q-40) to (Q-44) of the present invention and comparative photosensitive compositions (Q'-21) to (Q'-24), and coating film curability (curability-3) was evaluated by the following method. The results are shown in Table 3.

### [Curability]

Curability-3: Each of these photosensitive compositions was applied to a surface-treated 100 µm-thick PET (polyethylene terephthalate) film [COSMOSHINE A 4300 manufactured by Toyobo Co., Ltd.] with a thickness of 20 µm using an applicator. The photosensitive composition was exposed to light using an irradiator LIGHTNINGCURE Spot Light Source LC 8 (manufactured by Hamamatsu Photonics K.K.) as a light source, and curability was examined by the following evaluation method.

### Evaluation of curability:

⊙ The surface has no tackiness, and is not scratched even when scraped with a nail.
O The surface has no tackiness, but is scratched with a nail.
△ The surface remains tacky.
× The composition remains liquid, and is not cured.

**[Table 3]**

| | | Photosensitive composition | Onium salt (A) | Sensitizer (B) | Curability-3 |
|---|---|---|---|---|---|
| Example | 40 | Q-40 | A1-2 | B-2 | ⊙ |
| | 41 | Q-41 | A1-3 | B-2 | ⊙ |
| | 42 | Q-42 | A1-4 | B-2 | ⊙ |
| | 43 | Q-43 | A2-3 | B-2 | ⊙ |
| | 44 | Q-44 | A2-9 | B-2 | ⊙ |
| Comparative Example | 21 | Q'-21 | A'-1 | B-2 | ○ |
| | 22 | Q'-22 | A'-2 | B-2 | ○ |
| | 23 | Q'-23 | A'-3 | B-2 | ○ |
| | 24 | Q'-24 | A'-4 | B-2 | × |

### <Examples 45 to 49 and Comparative Examples 25 to 28: Examples of photosensitive compositions containing pigment>

### [Preparation of photosensitive composition]

### <Preparation of high-concentration dispersion (2)>

Except that the dye was changed to DIRECT BLUE 14 (manufactured by Tokyo Chemical Industry Co., Ltd.), the same procedure as in preparation of the above-described high-concentration dispersion (1) was carried out to prepare a dye dispersion.

### <Preparation of photosensitive composition>

Said high-concentration dye dispersant liquid of 47 parts, dipentaerythritol pentaacrylate of 46 parts ("NEOMER DA-600" manufactured by Sanyo Chemical Industries, Ltd.), 0.5 parts of the sensitizer (B-2), and 5 parts of the onium salt (A) or 5 parts of the comparative onium salt (A') as shown in Table 2 were kneaded at 25°C for 3 hours with a ball mill to produce photosensitive compositions (Q-45) to (Q-49) of the present invention and comparative photosensitive compositions (Q'-25) to (Q'-28), and coating film curability (curability-4) was evaluated by the following method. The results are shown in Table 4.

### [Curability]

Curability-4: Each of these photosensitive compositions was applied to a surface-treated 100 µm-thick PET (polyethylene terephthalate) film [COSMOSHINE A 4300 manufactured by Toyobo Co., Ltd.] with a thickness of 20 µm using an applicator. The photosensitive composition was exposed to light using an irradiator LIGHTNINGCURE Spot Light Source LC 8 (manufactured by Hamamatsu Photonics K.K.) as a light source, and curability was examined by the following evaluation method.

### Evaluation of curability:

⊙ The surface has no tackiness, and is not scratched even when scraped with a nail.
○ The surface has no tackiness, but is scratched with a nail.
△ The surface remains tacky.
× The composition remains liquid, and is not cured.

**[Table 4]**

| | | Photosensitive composition | Onium salt (A) | Sensitizer (B) | Curability-4 |
|---|---|---|---|---|---|
| Example | 45 | Q-45 | A1-2 | B-2 | ⊙ |
| | 46 | Q-46 | A1-3 | B-2 | ⊙ |
| | 47 | Q-47 | A1-4 | B-2 | ⊙ |
| | 48 | Q-48 | A2-3 | B-2 | ⊙ |
| | 49 | Q-49 | A2-9 | B-2 | ⊙ |
| Comparative Example | 25 | Q'-25 | A'-1 | B-2 | ○ |
| | 26 | Q'-26 | A'-2 | B-2 | Δ |
| | 27 | Q'-27 | A'-3 | B-2 | ○ |
| | 28 | Q'-28 | A'-4 | B-2 | × |

The results in Tables 3 and 4 show that the photosensitive composition of the present invention can be efficiently cured even when a substance such as a colorant, which attenuates or blocks radiated light, is present in a high concentration, and the photosensitive composition of the present invention has sensitivity higher than that of the comparative photosensitive composition.

### INDUSTRIAL APPLICABILITY

The photosensitive composition of the present invention utilizes light in a near-infrared region having a wavelength of 700 nm to 1200 nm, and is suitably used for coating agents, various coating materials (hard coats, anti-fouling coating materials, anti-fogging coating materials, anti-corrosion coating materials, optical fibers and the like), back surface treatment agents for pressure sensitive adhesive tapes, release coating materials of release sheets for pressure sensitive adhesive labels (release papers, release plastic films, release metal foils and the like), printing plates, dental materials (dental formulations and dental composites), ink compositions, inkjet ink compositions, positive resists (for formation of connection terminals and wiring patterns in production of electronic components such as circuit boards, CSP and MEMS elements), resist films, liquid resists and negative resists (permanent film materials of surface protecting films, interlayer dielectric films, planarizing films for semiconductor elements and transparent electrodes for FPD (ITO, IZO and GZO), etc.), resists for MEMS, positive photosensitive materials, negative photosensitive materials, various adhesives (various temporary fixing agents for electronic components, adhesives for HDD, adhesives for pick-up lenses, functional films for FPD (polarizing plates, antireflection films and the like), insulating films for circuit formation and semiconductor sealing, anisotropic electroconductive adhesives (ACA), films (ACF), pastes (ACP) and the like), holographic resins, FPD materials (color filters, black matrices, partition wall materials, photospacers, ribs, orientation films for liquid crystals, sealing agents for FPD and the like), optical members, molding materials (for building materials, optical components and lenses), casting materials, putty materials, glass fiber impregnating agents, fillers, sealing materials, flip-chips, chip sealants for COF etc., sealants for packages such as CSP or BGA, photosemiconductor (LED) sealants, optical waveguide materials, nano-imprint materials, stereolithography materials, and micro-stereolithography materials.

## Claims

1. A photosensitive composition containing the following essential components:
(A) an onium salt represented by the general formula (1);
(B) a sensitizer; and
(C) a radical polymerizable compound: 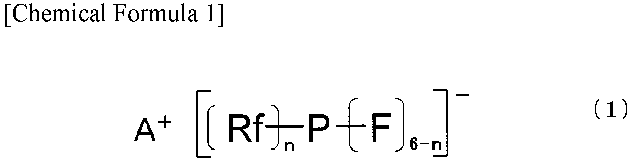 wherein in the formula (1), Rf each independently represents an alkyl group having a carbon number of 1 to 8, an alkenyl group having a carbon number of 2 to 8, or an aryl group having a carbon number of 6 to 10, where 80% or more of hydrogen atoms bonded to the carbon atoms of each group are substituted with fluorine atoms; n represents an integer of 1 to 5; and A⁺ represents a monovalent onium cation, **characterized in that** the sensitizer (B) is a polymethine-based dye selected from compounds of chemical formula 5 or chemical formula 6:

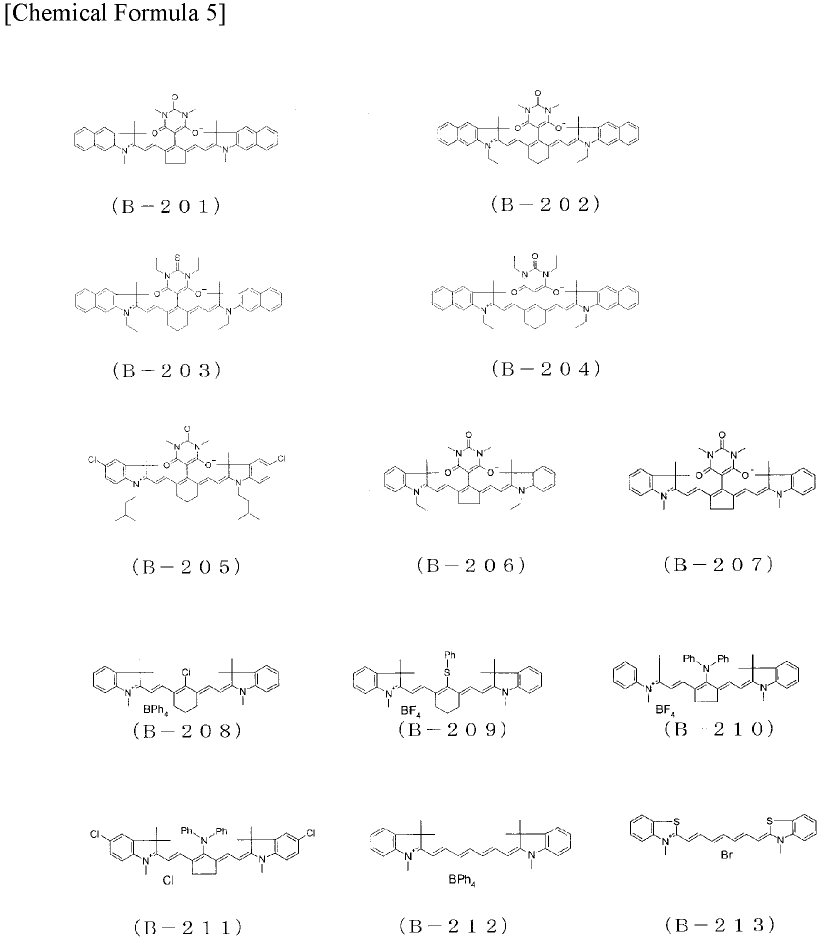

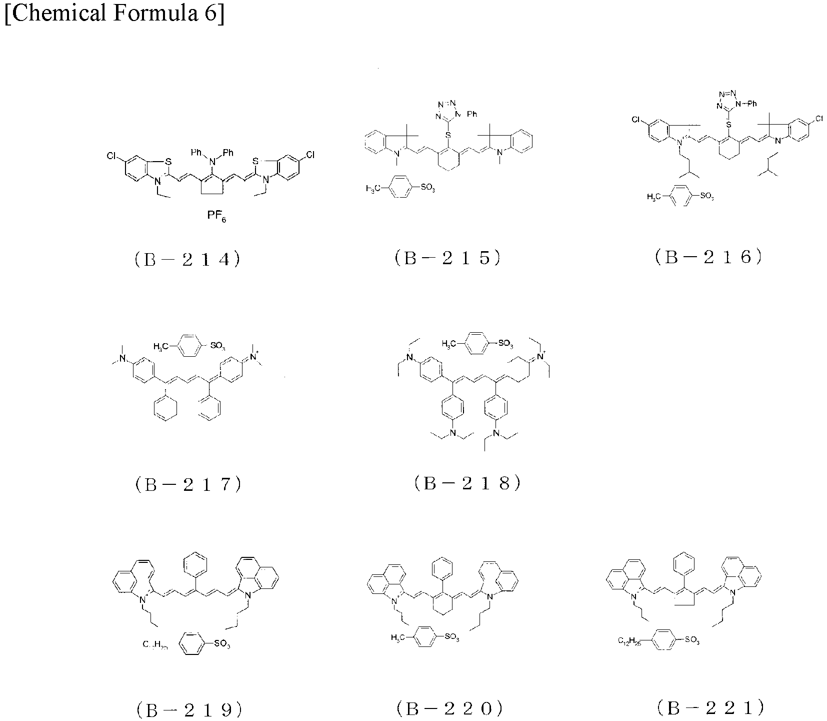

2. The photosensitive composition according to claim 1, wherein A⁺ in the general formula (1) is sulfonium or iodonium.

3. The photosensitive composition according to claim 1 or 2, wherein Rf in the general formula (1) independently represents an alkyl group having a carbon number of 1 to 8 in which 90% or more of hydrogen atoms are substituted with fluorine atoms.

4. A method for curing a photosensitive composition, the method comprising the step of irradiating the photosensitive composition according to any one of claims 1 to 3 with light in a near-infrared region having a wavelength of 700 nm to 1200 nm.

5. A cured product obtained by curing a photosensitive composition by the method according to claim 4.

## Patentansprüche

1. Eine lichtempfindliche Zusammensetzung, die die folgenden wesentlichen Bestandteile enthält:
(A) ein Oniumsalz, dargestellt durch die allgemeine Formel (1);
(B) einen Sensibilisator; und
(C) eine radikalisch polymerisierbare Verbindung: 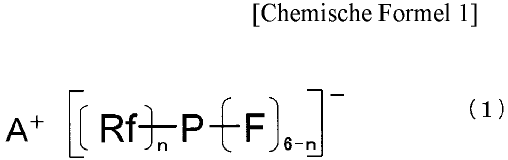 wobei in der Formel (1) Rf jeweils unabhängig voneinander eine Alkylgruppe mit einer Kohlenstoffzahl von 1 bis 8, eine Alkenylgruppe mit einer Kohlenstoffzahl von 2 bis 8 oder eine Arylgruppe mit einer Kohlenstoffzahl von 6 bis 10 darstellt, wobei 80 % oder mehr der an die Kohlenstoffatome jeder Gruppe gebundenen Wasserstoffatome durch Fluoratome substituiert sind; n eine ganze Zahl von 1 bis 5 darstellt; und A⁺ ein einwertiges Oniumkation darstellt,
***dadurch gekennzeichnet, dass*** der Sensibilisator (B) ein Farbstoff auf Polymethinbasis ist, ausgewählt aus Verbindungen der chemischen Formel 5 oder der chemischen Formel 6:

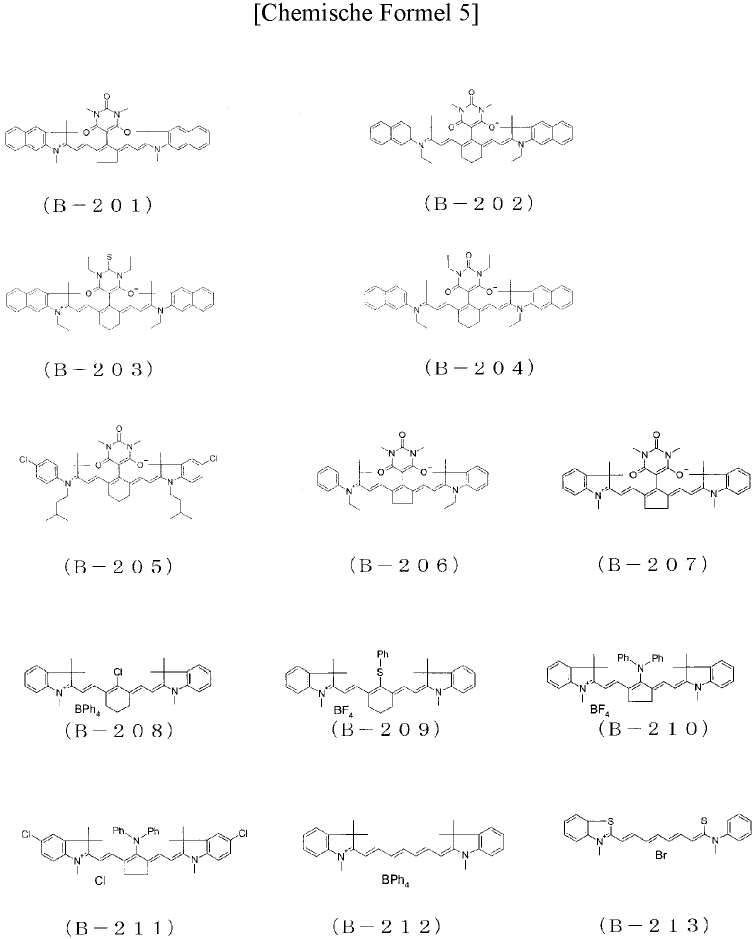

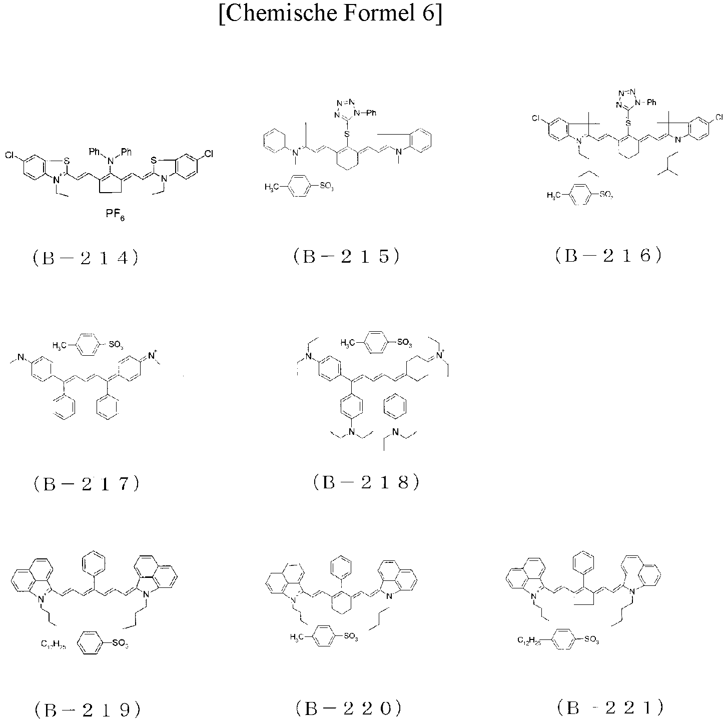

2. Die lichtempfindliche Zusammensetzung gemäß Anspruch 1, wobei A⁺ in der allgemeinen Formel (1) Sulfonium oder Iodonium ist.

3. Die lichtempfindliche Zusammensetzung gemäß Anspruch 1 oder 2, wobei Rf in der allgemeinen Formel (1) unabhängig eine Alkylgruppe mit einer Kohlenstoffzahl von 1 bis 8 darstellt, in der 90 % oder mehr der Wasserstoffatome durch Fluoratome substituiert sind.

4. Verfahren zum Härten einer lichtempfindlichen Zusammensetzung, wobei das Verfahren den Schritt des Bestrahlens der lichtempfindlichen Zusammensetzung nach einem der Ansprüche 1 bis 3 mit Licht im nahen Infrarotbereich mit einer Wellenlänge von 700 nm bis 1200 nm umfasst.

5. Gehärtetes Produkt, erhalten durch Härten einer lichtempfindlichen Zusammensetzung nach dem Verfahren gemäß Anspruch 4.

## Revendications

1. Composition photosensible contenant les composants essentiels suivants :
(A) un sel d'onium représenté par la formule générale (1) ;
(B) un agent de sensibilisation ; et
(C) un composé polymérisable par polymérisation radicalaire : 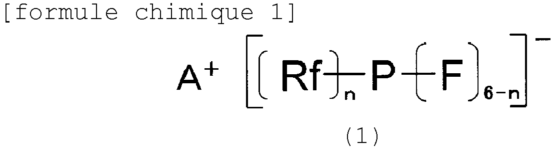 dans laquelle, dans la formule (1) chaque Rf représente indépendamment un groupe alkyle ayant 1 à 8 carbones, un groupe alcényle ayant 2 à 8 carbones, ou un groupe aryle ayant 6 à 10 carbones, où 80 % ou plus des atomes d'hydrogène liés aux atomes de carbone de chaque groupe sont remplacés par des atomes de fluor ; n représente un entier de 1 à 5 ; et A⁺ représente un cation onium monovalent,
**caractérisée en ce que** l'agent de sensibilisation (B) est un colorant à base de polyméthine choisi parmi les composés de formule chimique 5 ou de formule chimique 6 :

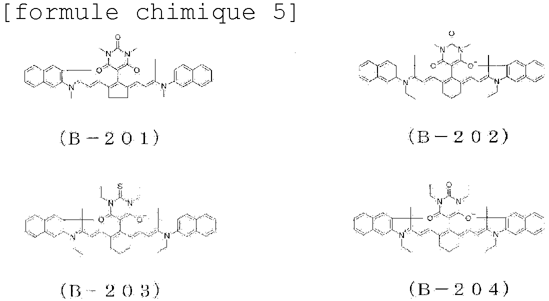

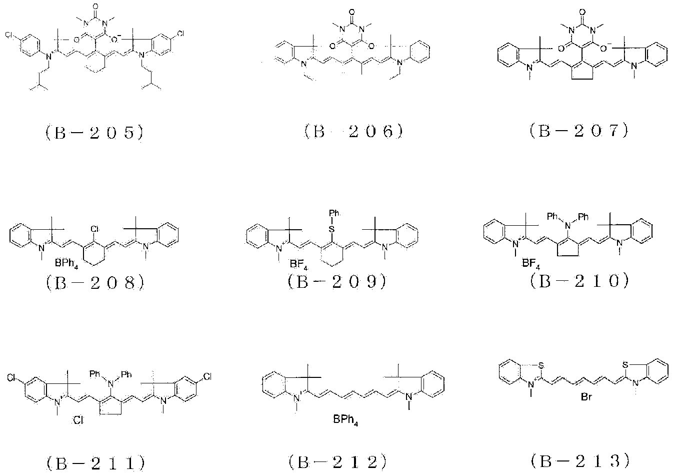

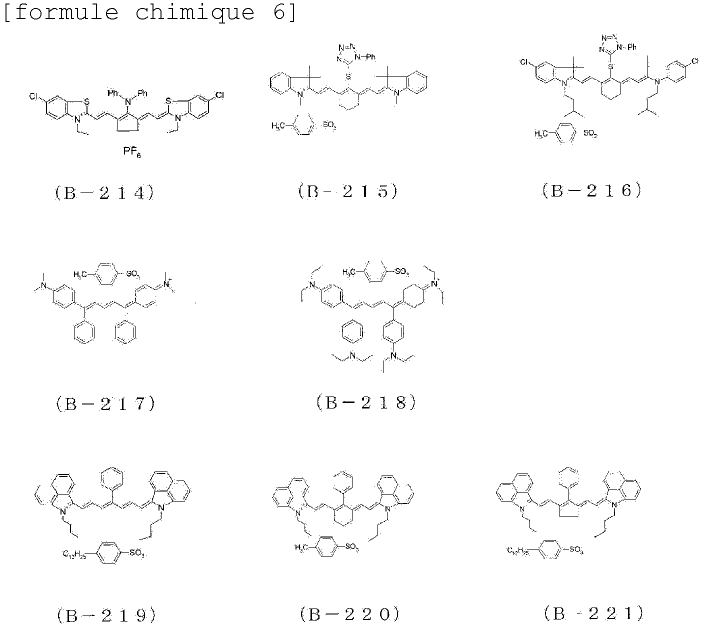

2. Composition photosensible selon la revendication 1, dans laquelle A⁺ dans la formule générale (1) est le sulfonium ou l'iodonium.

3. Composition photosensible selon la revendication 1 ou 2, dans laquelle Rf dans la formule générale (1) représente indépendamment un groupe alkyle ayant 1 à 8 carbones dans lequel 90 % ou plus des atomes d'hydrogène sont remplacés par des atomes de fluor.

4. Procédé pour durcir une composition photosensible, le procédé comprenant l'étape d'irradiation de la composition photosensible selon l'une quelconque des revendications 1 à 3 avec une lumière dans la région des proches infrarouges ayant une longueur d'onde de 700 nm à 1200 nm.

5. Produit durci obtenu par durcissement d'une composition photosensible par le procédé selon la revendication 4.
